(19) Europäisches Patentamt / European Patent Office / Office européen des brevets

(11) **EP 3 217 580 A1**

(12) **EUROPEAN PATENT APPLICATION**
published in accordance with Art. 153(4) EPC

(43) Date of publication:
**13.09.2017 Bulletin 2017/37**

(51) Int Cl.:
***H04L 1/00*** *(2006.01)*

(21) Application number: **15856502.8**

(22) Date of filing: **13.04.2015**

(86) International application number:
**PCT/CN2015/076490**

(87) International publication number:
**WO 2016/070573 (12.05.2016 Gazette 2016/19)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **07.11.2014 CN 201410624160**

(71) Applicant: **ZTE Corporation
Shenzhen, Guangdong 518057 (CN)**

(72) Inventors:
• **XU, Jin**
  **Shenzhen**
  **Guangdong 518057 (CN)**
• **XU, Jun**
  **Shenzhen**
  **Guangdong 518057 (CN)**
• **LI, Liguang**
  **Shenzhen**
  **Guangdong 518057 (CN)**

(74) Representative: **Novagraaf Technologies
Bâtiment O2
2, rue Sarah Bernhardt
CS90017
92665 Asnières-sur-Seine Cedex (FR)**

(54) **DATA CHECKING METHOD AND APPARATUS**

(57)　　Provided are a data checking method and device. The method includes: receiving a transmission signal containing a first data block and transmitted by a transmission node, wherein the length of the first data block is N bits, the first data block is generated by performing an FEC encoding on a second data block which has a length of K bits, and the second data block is generated by performing a CRC encoding on a third data block which has a length of L bits, where N, K and L are all positive integers, and $N \geq K > L$; obtaining a first estimation data block of the first data block according to the transmission signal, and obtaining a second estimation data block of the second data block according to the transmission signal; and checking the third data block according to a relationship between the first estimation data block and an FEC code space and/or a CRC check result of the second estimation data block. By means of the technical solution provided in the present disclosure, the problems that a transmission rate decreases due to the fact that a CRC check code is too long and a false detection rate cannot be ensured due to the fact that the CRC check code is too short are solved.

Receive a transmission signal containing a first data block and transmitted by a transmission node, wherein the length of the first data block is N bits, the first data block is generated by a second data block, the length of which is K bits, after FEC encoding, and the second data block is generated by a third data block, the length of which is L bits, after CRC encoding, where N, K and L are all positive integers, and $N \geq K > L$. —— S502

Obtain a first estimation data block of the first data block according to the transmission signal, and Obtain a second estimation data block of the second data block according to the transmission signal. —— S504

Check the third data block according to a relationship between the first estimation data block and an FEC code space and/or a CRC check result of the second estimation data block. —— S506

**Fig. 5**

EP 3 217 580 A1

## Description

## Technical Field

The present disclosure relates to the field of communications, and more particularly to a data checking method and device.

## Background

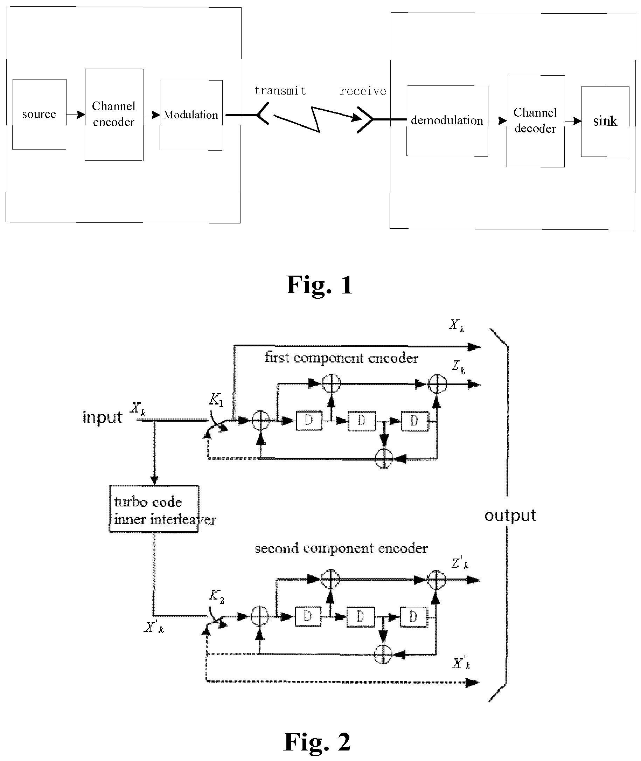

The transmitter of a digital communication system usually includes a source, a channel encoder, a modulator, and other parts, and the receiver usually includes a demodulator, a channel decoder, and an Sink. Fig. 1 is a schematic diagram of a digital communication system in the related art. As shown in Fig. 1, the channel encoder is used to introduce redundant information to the information bits in accordance with a certain rule so that the receiver channel decoder can correct error codes that occur when the information is transmitted over the channel to a certain extent. Therefore, channel encoding is a Forward Error Correction (FEC) technology.

In general, FEC encoding is a process of generating a parity bit sequence from an information bit sequence. The information bit sequence and the parity bit sequence together form a commonly used codeword bit sequence. The commonly used FEC encoding includes Turbo codes, Low Density Parity Check codes (LDPC) and convolution codes. For example, a Turbo code is used in the Long-Term Evolution (LTE) system for data transmission; an LDPC code and a convolution code are used in the IEEE 802.11 system.

The binary Turbo encoding of LTE is a parallel concatenated code with inner interleaver, which is usually concatenated by two Recursive System Code (RSC) component code encoders with the same structure. The Turbo code interleaver randomly substitutes the bit positions in the input binary information sequence before the second component code encoder, and when the interleaver is sufficiently large, the Turbo code has a characteristic of an approximately random long code. The encoding structure of the Turbo code is as shown in Fig. 2. The input binary information sequence $X_k$ generates a check sequence $Z_k$ through the first component code encoder. At the same time, after the $X_k$ is interleaved through the Turbo code interleaver, another check sequence $Z'_k$ is generated by the second component code encoder.

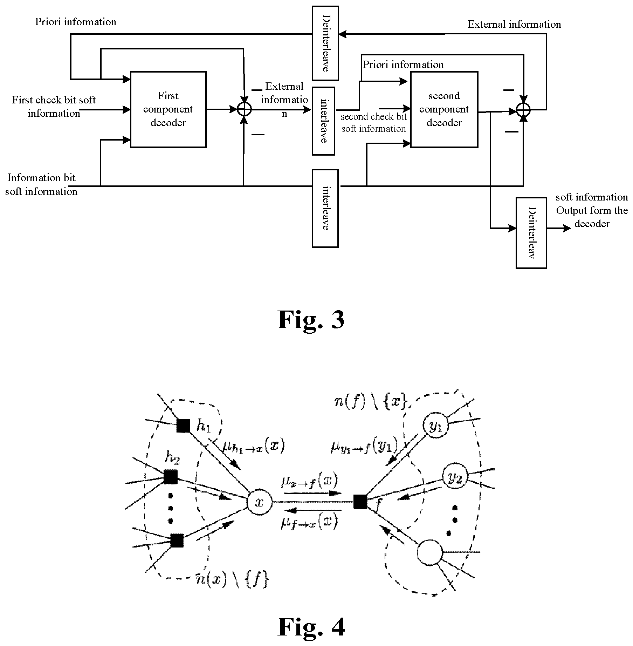

The Turbo code decoder is also formed by two cascaded sub-decoders, the first component decoder and the second component decoder, respectively, as shown in Fig. 3, the side information (also referred to as extrinsic information) of the information bit output by the first component decoder is input to the second component decoder as prior information after the inner interleaving of the Turbo code. Likewise, the side information of the information bit output by the second component decoder is input to the first component decoder as prior information after being deinterleaved, thus forming an iterative decoding structure. The soft information output by the decoder is the sum of the side information output by the second component decoder plus the input prior information and the soft information input by the channel after being deinterleaved. After several iterations, the decoder judges the output soft information to generate an estimation of the information bit sequence by the decoder.

LDPC code is a linear block code based on a sparse parity check matrix, which can achieve the code of low complexity with the use of its parity check matrix sparsity. The graphical representation of the LDPC parity check matrix is a bipartite graph. There is a one-to-one correspondence between the bipartite graph and the parity check matrix H, and an M * N parity check matrix H defines the constraint that each codeword with N bits satisfies M parity check sets. A bipartite graph includes N variable nodes and M parity check nodes. When the mth check involves the nth bit, that is, the element Hm of the mth row and the nth column in H, where n = 1, there will be a connecting line to connect the check node m and the variable node n. In the bipartite graph, there is no connection between any nodes of the same class, and the total number of edges in the bipartite graph is equal to the number of nonzero elements in the parity check matrix.

The decoding of the LDPC code may employ an iterative algorithm (referred to as a belief propagation algorithm) based on belief propagation. The belief propagation algorithm is a decoding algorithm based on the bipartite graph structure. Since the reliability information is transmitted back and forth between the variable nodes and the check nodes in the process of running the algorithm, it is referred to as the belief propagation algorithm. The belief propagation algorithm has two forms, probabilistic domain and logarithmic domain. The probability domain algorithm involves more multiplication, which is relatively expensive in implementation and is relatively poor in the numerical stability. The logarithmic domain algorithm is mainly an addition, which is easy to implement and is also relatively better in the numerical stability. Fig. 4 shows a decoding process of the belief propagation algorithm based on a bipartite graph, where a check node (a square node) represents a check equation, and a variable node (a circular node) represents a codeword bit. In the process of iterative decoding, the reliability information is transmitted back and forth between the variable node and the check node of the binary graph. The information transmitted by the variable node to the check node is the external information of value range of the codeword bit. The information transmitted by the check node to the variable node is the reliability information that the check of the check equation has passed. The LDPC decoder based on the belief propagation algorithm can output the soft information of the codeword bits (including the information bits and the parity bits) after iteration. After several iterations, the decoder judges the output soft information to generate an estimation of the information bit sequence by the decoder.

The convolution code is another commonly used FEC code. The characteristic of the convolution code is that when the input information at a certain moment is encoded, the output codeword is determined together not only on the basis of the input at this moment but also on the basis of the input at p moments before this moment, that is, the generation of the codeword is limited by p + 1 input moments. The convolution code is a finite state machine, and its encoding and decoding can be analyzed with the help of a grid diagram.

The basic idea of the decoding of the convolution code is to calculate the distance between it and all other possible and continuous grid paths on the basis of the received codewords, and select one of the most possible distances as the decoded estimation. The most commonly used convolution code decoding algorithm is Viterbi algorithm proposed by Viterbi in 1967. The Viterbi algorithm is essentially a maximum likelihood decoding. The classic Viterbi algorithm can only output hard decision information. We can also use Soft-Output Viterbi Algorithm (SOVA) or BCJR algorithm and other soft output decoding algorithms to generate soft information on information bits. The SOVA algorithm is a soft-output Viterbi algorithm proposed by Hagenauer and Hoeher in 1984. BCJR algorithm is a Maximum A Posteriori (MAP) decoding algorithm, which is proposed by Bahl, Cocke, Jelinek and Raviv in 1974.

The decoding method of the various FEC codes described above can obtain a decoding estimation with respect to the codeword bits or the information bits. But some error detecting means should be taken to know whether the decoding result is correct. Cyclic Redundancy Check code (CRC) is a system shortening cycle code, but also a good error detecting code. Because the CRC has the characteristics such as a low complexity and an excellent performance, it is widely used in a variety of communication systems. In the familiar 3Gpp LTE protocol, a large number of CRCs are used from the physical layer to an upper layer to check the correctness of the data.

In the existing LTE system, the physical layer data sharing channel performs data transmission with a Transmission Block (TB) as the basic unit. The receiver uses the CRC of the TB to determine whether the current TB is correctly received. If the TB is correctly received, the receiver will feed back an ACK message to the transmitting end. If the TB is not received correctly, the receiver will feed back the NACK message to the transmitting end.

When the block size of the TB exceeds the specified threshold, for example, 6120 bits, the transmitting end usually performs Code Block (CB) division, dividing one TB into multiple CBs. After performing encoding, rate matching, code block cascading, modulating and other operations, each CB is then transmitted to the receiver.

The LTE protocol specifies that when a TB includes multiple CBs, each CB also adds a CRC before encoding, and the CRC of the CB is used for the early termination of the decoding.

The LTE protocol specifies CRCs of a total of three lengths, such as 24, 16, and 8 bits, and in the physical shared channel data transmission, TB CRC and CB CRC have 24 bits, but the two CRCs have different generation polynomials.

With the emergence of new applications such as Internet of Things and Machine Type Communication (MTC), small packet communication services of a large number of users are becoming more and more important. Small packets usually refer to the data that a single TB block has a length of tens to hundreds of bits. According to the existing LTE protocol, TB of this length still needs to add a TB CRC with a length of 24 bits. Although the 24-bit CRC can provide good error detecting performance, for small packets, it will bring a greater redundancy rate, thereby reducing the wireless channel transmission efficiency. For example, after adding a 24-bit TB CRC, a TB block with a length of 24 bits has a redundancy rate of 50%, and the actual redundancy rate will be further increased after the channel encoding; even if it is a TB block with a length of 208 bits, the redundancy rate will be at least 10.3% after adding a 24-bit CRC.

How to reduce the redundancy of small packets and improve the transmission efficiency? An easily conceivable way is to reduce the length of the CRC, for example, to reduce the TB CRC of the packet from 24 bits to 8 bits. However, the drawback of this method is also very obvious: reducing the length of the CRC will cause an increase in the false detection rate. For example, 8-bit CRC can only be used for TB blocks with a length of no more than $2^7-1-127$ bits, and the false detection rate is close to 4%. The higher false detection rate cannot meet the requirements of the actual system.

In addition, in other wireless broadband communication systems, such as the IEEE 802.11 system, there is no code block CRC, and a code block size is usually only hundreds of bits. If the efficiency of data retransmission should be improved, some improvements can be made to the system. For example, adding CB CRC to the code block, so that the receiver can know the status of the various code blocks, so as to design some efficient data retransmission schemes. However, if the CRC length is too long, it will also cause a decrease in the actual transmission efficiency. If the CRC length is too short, it cannot meet the requirement of the false detection rate.

No effective technical solution has been proposed for the problems in the related art that a transmission rate decreases due to the fact that a CRC check code is too long and a false detection rate cannot be ensured due to the fact that the CRC check code is too short.

## Summary

In certain embodiments of the present disclosure, data checking methods and devices are provided.

According to one embodiment of the present disclosure, a data checking method is provided, which includes: receiving a transmission signal containing a first data block and transmitted by a transmission node, and the length of the first data block is N bits, the first data block is generated by a second data block, the length of which is K bits, after FEC encoding, and the second data block is generated by a third data block, the length of which is L bits, after CRC encoding, where N, K and L are all positive integers, and N≥K>L; obtaining a first estimation data block of the first data block according to the transmission signal, and obtaining a second estimation data block of the second data block according to the transmission signal; and checking the third data block according to a relationship between the first estimation data block and an FEC code space and/or a CRC check result of the second estimation data block.

In certain embodiments, checking the third data block according to a relationship between the first estimation data block and an FEC code space and/or a CRC check result of the second estimation data block, includes: judging that the third data block is received correctly when the first estimation data block is a codeword of the FEC code space and the CRC check of the second estimation data block is correct; and judging that the third data block is not received correctly when the first estimation data block is not a codeword of the FEC code space and/or the CRC check of the second estimation data block fails.

In certain embodiments, the first estimation data block is a codeword of the FEC code space when the first data block is a code block or a transmission block containing a code block, indicating that: the code block or the transmission block is a codeword in the FEC code space; or the first estimation data block is a codeword of the FEC code space when the first data block is a transmission block containing a plurality of data blocks, indicating that: the plurality of data blocks are codewords in the FEC code space.

In certain embodiments, when it is judged that the third data block is received correctly, Acknowledgment (ACK) information is transmitted to the transmission node; and when it is judged that the third data block is not received correctly, Non-Acknowledgment (NACK) information is transmitted to the transmission node.

In certain embodiments, the FEC encoding includes at least one of: a Turbo code, a LDPC code, and a convolution code.

In certain embodiments, when the FEC encoding is a Turbo code, it is determined whether the data block is a codeword in the FEC code space by at least one of the following manners one to seven.

Manner one:

comparing side information $\Lambda_i^{e_1}$ corresponding to K bits output by a first component decoder after the jth iteration with the first threshold $Y_1$, respectively,

if $\Lambda_i^{e_1} \geq Y_1$, the bit i is judged to be "1", if $\Lambda_i^{e_1} < Y_1$, the bit i is judged to be 0, and generating the bit sequence $E_1$ according to the judging result, where i is an integer and i ∈ {0,1,2,... K-1}, j is an integer greater than or equal to 1, and $e_1$ represents that the $\Lambda_i^{e_1}$ is the side information output by the first component decoder;

comparing side information $\Lambda_i^{e_2}$ corresponding to K bits output by a second component decoder in the jth iteration with the first threshold $Y_1$, respectively, and if $\Lambda_i^{e_2} \geq Y_1$, the bit i is judged to be "1", if $\Lambda_i^{e_2} < Y_1$, the bit i is judged to be 0, and generating the bit sequence $E_2$ according to the judging result, where $e_2$ represents that the $\Lambda_i^{e_2}$ is the side information output by the second component decoder; interleaving the bit sequence $E_1$ using an inner interleaver pattern of the Turbo code, generating an interleaved bit sequence $E_1^{int}$, and comparing the size relationship between $E_1^{int}$ and $E_2$, and if the $E_1^{int}= E_2$, the data block generated by being decoded by the Turbo code after j iterations is a codeword in the FEC code space; if $E_1^{int} \neq E_2$, the data block generated after j iterations is not a codeword in the FEC code space, where int represents that the $E_1^{int}$ is the interleaved information or bit sequence; or deinterleaving the $E_2$ using an inner interleaver of the Turbo code, generating an deinterleaved bit sequence $E_2^{dei}$, and comparing $E_1$ and $E_2^{dei}$, and if the $E_2^{dei} = E_1$, the data block generated by being encoded by the Turbo code after j iterations is a codeword in the FEC code space; if $E_2^{dei} \neq E_1$, the data block generated after j iterations is not a codeword in the FEC code space, where dei represents that the $E_2^{dei}$ is the deinterleaved information or bit sequence.

Manner two:

comparing the symbol $\operatorname{sign}(\Lambda_i^j)$ of soft information of K bits output by the Turbo code decoder after the jth iteration with the soft information $\operatorname{sign}(\Lambda_i^{j-1})$ output by a decoder after the j-1th iteration, and if $\operatorname{sign}(\Lambda_i^j)$ and $\operatorname{sign}(\Lambda_i^{j-1})$ of each bit are the same, the data block generated by the Turbo code decoder after the jth iteration is a codeword in the FEC code space; and $\operatorname{sign}(\Lambda_i^j)$ and $\operatorname{sign}(\Lambda_i^{j-1})$ of at least one bit are different, the data block generated by the Turbo code decoder after the jth iteration is not a codeword in the FEC code space, where i is an integer and i ∈ {0,1,2,... K-1}, j is an integer greater than or equal to 2.

Manner three:

comparing the symbol $\mathrm{sign}(\Lambda_i^j)$ of soft information of K bits output by the Turbo code decoder after the jth iteration with the soft information $\mathrm{sign}(\Lambda_i^{j-1})$ output by a decoder after the j-1th iteration, and if the number of bits in which $\mathrm{sign}(\Lambda_i^j)$ and $\mathrm{sign}(\Lambda_i^{j-1})$ are the same is less than or equal to a second threshold $Y_2$, the data block generated after the jth iteration is not a codeword in the FEC code space, where i is an integer and i ∈ {0,1,2,... K-1}, j is an integer greater than or equal to 2; or

if the number of bits in which $\mathrm{sign}(\Lambda_i^j)$ and $\mathrm{sign}(\Lambda_i^{j-1})$ are different is less than or equal to a third threshold $Y_3$, the data block generated by the Turbo code decoder after the jth iteration is a codeword in the FEC code space; and if the number of bits in which $\mathrm{sign}(\Lambda_i^j)$ and $\mathrm{sign}(\Lambda_i^{j-1})$ are different is greater than the third threshold $Y_3$, the data block generated after the jth iteration is not a codeword in the FEC code space.

Manner four:

comparing the symbol $\mathrm{sign}(\Lambda_i^{a_2})$ of priori information of K bits input to a second component decoder in the jth iteration and the symbol $\mathrm{sign}(\Lambda_i^{e_2})$ of side information of K bits output by a second component decoder in the jth iteration, and if the number of bits in which $\mathrm{sign}(\Lambda_i^{a_2})$ and $\mathrm{sign}(\Lambda_i^{e_2})$ are the same is less than or equal to a fourth threshold $Y_4$, the data block generated by the Turbo code decoder after the jth iteration is a codeword in the FEC code space, where i is an integer and i ∈ {0,1,2,... K-1}, j is an integer greater than or equal to 2, where a2 represents that the $\mathrm{sign}(\Lambda_i^{a_2})$ is priori information input to the second component decoder; or

if the number of bits in which $\mathrm{sign}(\Lambda_i^{a_2})$ and $\mathrm{sign}(\Lambda_i^{e_2})$ are different is less than or equal to a fifth threshold $Y_5$, the data block generated by the Turbo code decoder after the jth iteration is a codeword in the FEC code space; and if the number of bits in which $\mathrm{sign}(\Lambda_i^{a_2})$ and $\mathrm{sign}(\Lambda_i^{e_2})$ are different is greater than the fifth threshold $Y_5$, the data block generated after the jth iteration is not a codeword in the FEC code space.

Manner five:

comparing the absolute value $\left|\Lambda_i^j\right|$ of the soft information of K bits output by the Turbo code decoder after the jth iteration with a sixth threshold $Y_6$, and if the maximum value in $\left|\Lambda_i^j\right|$ is greater than the sixth threshold $Y_6$, the data block generated by the Turbo code decoder after the jth iteration is a codeword in the FEC code space; and if the minimum value in $\left|\Lambda_i^j\right|$ is less than or equal to the sixth threshold $Y_6$, the data block generated by the Turbo code decoder after the jth iteration is not a codeword in the FEC code space, where i is an integer and i ∈ {0,1,2,... K-1}, j is an integer greater than or equal to 1.

Manner six:

$$S^j = \frac{1}{\mathrm{K}}\sum_{i=1}^{k}\left|\Lambda_i^j\right|$$

comparing the mean value of the absolute value of the soft information of K bits output by the Turbo code decoder after the jth iteration with a seventh threshold $Y_7$, and if $S^j$ is greater than the seventh threshold $Y_7$, the data block generated by the Turbo code decoder after the jth iteration is a codeword in the FEC code space; and if $S^j$ is less than or equal to the seventh threshold $Y_7$, the data block generated by the Turbo code decoder after the jth iteration is not a codeword in the FEC code space, where i is an integer and i ∈ {0,1,2,... K-1}, j is an integer greater than or equal to 1.

Manner seven:

$$S^j = \sum_{i=1}^{k}\left|\Lambda_i^j\right|$$

comparing the sum of the absolute value of the soft information of K bits output by the Turbo code decoder after the jth iteration with the sum $S^{j-1} = \sum_{i=1}^{k}\left|\Lambda_i^{j+1}\right|$ of the absolute value of the soft information of K bits output by the Turbo code decoder after the j-1th iteration, and if $S^j$ is less than or equal to $S^{j-1}$, the data block generated by the Turbo code decoder after the jth iteration is a codeword in the FEC code space; and if $S^j$ is greater than $S^{j-1}$, the data block generated by the Turbo code decoder after the jth iteration is not a codeword in the FEC code space, where i is an integer and i ∈ {0,1,2,... K-1}, j is an integer greater than or equal to 2, and the first threshold $Y_1$ to the seventh threshold $Y_7$ are integers greater than or equal to zero.

In certain embodiments, when the FEC encoding is the LDPC code, it is determined whether the data block is a codeword in the FEC code space by at least one of the following manners one to seven.

Manner one:

comparing soft information $\Lambda_i^j$ of N codeword bits output by an LDPC code decoder after the jth iteration with the eighth threshold $Y_8$, and if $\Lambda_i^j \geq Y_8$, the bit i is judged to be "1 ", if $\Lambda_i^j < Y_8$, the bit i is judged to be 0, and generating the estimation $\tilde{E}$ of the data block according to the judging result, where i is an integer and i ∈ {0,1,2,... N-1}, j is an integer greater than or equal to 1;

if $\tilde{E} \times H^T = 0$, $\tilde{E}$ generated by the LDPC code decoder after the jth iteration is a codeword in the FEC code space; and if $\tilde{E} \times H^T \neq 0$, the $\tilde{E}$ is not a codeword in the FEC code space, where H is a check matrix of the LDPC code.

Manner two:

comparing soft information $\Lambda_i^j$ of N codeword bits output by an LDPC code decoder after the jth iteration with the eighth threshold $Y_8$, and if $\Lambda_i^j \geq Y_8$, the bit i is judged to be "1 ", if $\Lambda_i^j < Y_8$, the bit i is judged to be 0, generating the estimation $\tilde{E}$ of the first data block according to the judging result, and generating the estimation $\tilde{F}$ of the bit sequence by taking the first K bits for the estimation $\tilde{E}$, where i is an integer and i ∈ {0,1,2,... N-1}, j is an integer greater than or equal to 1;

generating the data block C by performing LDPC encoding on the $\tilde{F}$, and if $\tilde{E} = C$, the $\tilde{E}$ is a codeword in the FEC code space; and if $\tilde{E} \neq C$, the $\tilde{E}$ is not a codeword in the FEC code space.

Manner three:

comparing the symbol $\mathrm{sign}(\Lambda_i^j)$ of soft information of N codeword bits output by a LDPC code decoder after the jth iteration with the soft information $\mathrm{sign}(\Lambda_i^{j-1})$ output by a decoder after the j-1th iteration, and if $\mathrm{sign}(\Lambda_i^j)$ and $\mathrm{sign}(\Lambda_i^{j-1})$ of each bit are the same, the data block generated by the LDPC code decoder after the jth iteration is a codeword in the FEC code space; and if $\mathrm{sign}(\Lambda_i^j)$ and $\mathrm{sign}(\Lambda_i^{j-1})$ of at least one bit are different, the data block generated after the jth iteration is not a codeword in the FEC code space, where i is an integer and i ∈ {0,1,2,... N-1}, j is an integer greater than or equal to 2.

Manner four:

comparing the symbol $\mathrm{sign}(\Lambda_i^j)$ of soft information of N codeword bits output by a LDPC code decoder after the jth iteration with the soft information $\mathrm{sign}(\Lambda_i^{j-1})$ output by a decoder after the j-1 th iteration, and if the number of bits in which $\mathrm{sign}(\Lambda_i^j)$ and $\mathrm{sign}(\Lambda_i^{j-1})$ are the same is greater than or equal to a ninth threshold $Y_9$, the data block generated by the LDPC code decoder after the jth iteration is a codeword in the FEC code space; if the number of bits in which $\mathrm{sign}(\Lambda_i^j)$ and $\mathrm{sign}(\Lambda_i^{j-1})$ are different is less than or equal to the ninth threshold $Y_9$, the data block generated after the jth iteration is not a codeword in the FEC code space, where i is an integer and i ∈ {0,1,2,... N-1}, j is an integer greater than or equal to 2; or

if the number of bits in which $\mathrm{sign}(\Lambda_i^j)$ and $\mathrm{sign}(\Lambda_i^{j-1})$ are different is less than or equal to a tenth threshold $Y_{10}$, the data block generated by the LDPC code decoder after the jth iteration is a codeword in the FEC code space; and if the number of bits in which $\mathrm{sign}(\Lambda_i^j)$ and $\mathrm{sign}(\Lambda_i^{j-1})$ are different is greater than the tenth threshold $Y_{10}$, the data block generated after the jth iteration is not a codeword in the FEC code space.

Manner five:

comparing the absolute value of the soft information of N codeword bits output by the LDPC code decoder after the jth iteration with an eleventh threshold $Y_{11}$, and if the minimum value in $\left|\Lambda_i^j\right|$ is greater than the eleventh threshold $Y_{11}$, the data block generated by the LDPC code decoder after the jth iteration is a codeword in the FEC code space; and if the minimum value in $\left|\Lambda_i^j\right|$ is less than or equal to the eleventh threshold $Y_{11}$, the data block generated by the LDPC code decoder after the jth iteration is not a codeword in the FEC code space, where i is an integer and i ∈ {0,1,2,... N-1}, j is an integer greater than or equal to 1.

Manner six:

$$S^j = \frac{1}{N} \sum_{i=1}^{k} \left|\Lambda_i^j\right|$$

comparing the mean value $S^j = \frac{1}{N} \sum_{i=1}^{k} \left|\Lambda_i^j\right|$ of the absolute value of the soft information of N codeword bits output by the LDPC code decoder after the jth iteration with a twelfth threshold $Y_{12}$, and if $S^j$ is greater than the twelfth threshold $Y_{12}$, the data block generated by the LDPC code decoder after the jth iteration is a codeword in the FEC code space; and if $S^j$ is less than or equal to the twelfth threshold $Y_{12}$, the data block generated by the LDPC code decoder after the jth iteration is not a codeword in the FEC code space, where i is an integer and i $\in$ {0,1,2,... N-1}, j is an integer greater than or equal to 1.

Manner seven:

comparing the sum
$$S^j = \sum_{i=1}^{k} \left| \Lambda_i^j \right|$$
of the absolute value of the soft information of N codeword bits output by the LDPC code decoder after the jth iteration with the sum
$$S^j = \sum_{i=1}^{k} \left| \Lambda_i^{j-1} \right|$$
of the absolute value of the soft information of N codeword bits output by the LDPC code decoder after the j-1th iteration, and if $S^j$ is less than or equal to $S^{j-1}$, the data block generated by the LDPC code decoder after the jth iteration is a codeword in the FEC code space; and if $S^j$ is greater than $S^{j-1}$, the data block generated by the LDPC code decoder after the jth iteration is not a codeword in the FEC code space, where i is an integer and i $\in$ {0,1,2,... N-1}, j is an integer greater than or equal to 2, and the eighth threshold $Y_8$ to the twelfth threshold $Y_{12}$ are integers greater than or equal to zero.

In certain embodiments, when the FEC encoding is the convolution code, it is determined whether the data block is a codeword in the FEC code space by at least one of the following manners one to five.

Manner one:

comparing the symbol $\mathrm{sign}(\Lambda_i^j)$ of soft information of K bits output by the convolution code decoder after the jth iteration with the soft information $\mathrm{sign}(\Lambda_i^{j-1})$ output by a decoder after the j-1th iteration, and if $\mathrm{sign}(\Lambda_i^j)$ and $\mathrm{sign}(\Lambda_i^{j-1})$ of each bit are the same, the data block generated by the convolution code decoder after the jth iteration is a codeword in the FEC code space; and if $\mathrm{sign}(\Lambda_i^j)$ and $\mathrm{sign}(\Lambda_i^{j-1})$ of at least one bit are different, the data block generated after the jth iteration is not a codeword in the FEC code space, where i is an integer and i $\in$ {0,1,2,... K-1}, j is an integer greater than or equal to 2.

Manner two:

comparing the symbol $\mathrm{sign}(\Lambda_i^j)$ of soft information of K bits output by the convolution code decoder after the jth iteration with the soft information $\mathrm{sign}(\Lambda_i^{j-1})$ output by a decoder after the j-1th iteration, and if the number of bits in which $\mathrm{sign}(\Lambda_i^j)$ and $\mathrm{sign}(\Lambda_i^{j-1})$ are the same is greater than or equal to a thirteenth threshold $Y_{13}$, the data block generated after the jth iteration is a codeword in the FEC code space; and if the number of bits in which $\mathrm{sign}(\Lambda_i^j)$ and $\mathrm{sign}(\Lambda_i^{j-1})$ are the same is less than or equal to the thirteenth threshold $Y_{13}$, the data block generated after the jth iteration is not a codeword in the FEC code space, where i is an integer and i $\in$ {0,1,2,... K-1}, j is an integer greater than or equal to 2; or

if the number of bits in which $\mathrm{sign}(\Lambda_i^j)$ and $\mathrm{sign}(\Lambda_i^{j-1})$ are different is greater than or equal to a fourteenth threshold $Y_{14}$, the data block generated by the convolution code decoder after the jth iteration is a codeword in the FEC code space; and if the number of bits in which $\mathrm{sign}(\Lambda_i^j)$ and $\mathrm{sign}(\Lambda_i^{j-1})$ are different is greater than the fourteenth threshold $Y_{14}$, the data block generated after the jth iteration is not a codeword in the FEC code space.

Manner three:

comparing the absolute value $\left| \Lambda_i^j \right|$ of the soft information of K bits output by the convolution code decoder after the jth iteration with a fifteenth threshold $Y_{15}$, and if the maximum value in $\left| \Lambda_i^j \right|$ is greater than the fifteenth threshold $Y_{15}$, the data block generated by the convolution code decoder after the jth iteration is a codeword in the FEC code space; and if the minimum value in $\left| \Lambda_i^j \right|$ is less than or equal to the fifteenth threshold $Y_{15}$, the data block generated after the jth iteration is not a codeword in the FEC code space, where i is an integer and i $\in$ {0,1,2,... K-1}, j is an integer greater than or equal to 1.

Manner four:

comparing the mean value
$$S^j = \frac{1}{K} \sum_{i=1}^{k} \left| \Lambda_i^j \right|$$
of the absolute value of the soft information of K bits output by the convolution code decoder after the jth iteration with a sixteenth threshold $Y_{16}$, and if $S^j$ is greater than the sixteenth threshold $Y_{16}$, the data block generated by the convolution code decoder after the jth iteration is a codeword in the FEC code space; and if $S^j$ is less than or equal to the sixteenth threshold $Y_{16}$, the data block generated after the jth iteration is not a codeword in the FEC code space, where i is an integer and i $\in$ {0,1,2,... K-1}, j is an integer greater than or equal to 1.

Manner five:

$$S^j = \sum_{i=1}^{k} \left| \Lambda_i^{j} \right|$$

comparing the sum ___ of the absolute value of the soft information of K bits output by the convolution code decoder after the jth iteration with

$$S^{j-1} = \sum_{i=1}^{k} \left| \Lambda_i^{j-1} \right|$$

the sum ___ of the absolute value of the soft information of K bits output by the LDPC code decoder after the j-1th iteration, and if $S^j$ is less than or equal to $S^{j-1}$, the data block is a codeword in the FEC code space; and if $S^j$ is greater than $S^{j-1}$, the data block is not a codeword in the FEC code space, where i is an integer and i $\in$ {0,1,2,... K-1}, j is an integer greater than or equal to 2, and the thirteenth threshold $Y_{13}$ to the sixteenth threshold $Y_{16}$ are integers greater than or equal to zero.

In certain embodiments, the method further includes: determining the length of the CRC according to the length L of the third data block.

In certain embodiments, the length of the CRC is determined according to the length L of the third data block, including: dividing the range of values of the length L into T intervals in an ascending order: $L_1,L_2,......L_T$, where each interval corresponds to the CRCs of different lengths: $L_1^{CRC}, L_2^{CRC}, ...... L_T^{CRC}$, and $L_1^{CRC}, L_2^{CRC}, ...... L_T^{CRC}$, and T is a positive integer; and selecting the length of the CRC used for encoding the third data block according to the value interval to which the length L of the third data block belongs.

In certain embodiments, the transmission node includes at least one of: a base station, a relay node, and a terminal.

In certain embodiments, when the transmission node is a terminal, a transmission signaling for indicating a data checking mode is transmitted to the transmission node, and the data checking mode includes at least one of: checking data according to the FEC code space and/or the CRC check result; and checking data according to the CRC check result.

In certain embodiments, when the transmission node is a base station or a relay node, an indication signaling for configuring the data checking mode and transmitted by the transmission node is received, and the data checking mode includes at least one of: checking data according to the FEC code space and/or the CRC check result; checking data according to the CRC check result.

In certain embodiments, and a data checking mode in which data is checked according to the FEC code space and/or the CRC check result is used in one of the following cases: the length of the transmission block or code block in the first data block is less than the first preset threshold; or the number of repetitions of the transmission block or code block in the first data block is greater than the second preset threshold.

In certain embodiments, the FEC code space includes: a set of all codewords generated using the FEC encoding manner.

In certain embodiments, the first estimation data block of the first data block is obtained according to the transmission signal, including: obtaining the first estimation data block by demodulating the transmission signal; and the second estimation data block of the second data block is obtained according to the transmission signal, including: obtaining the second estimation data block by demodulating and FEC decoding the transmission signal.

According to another embodiment of the present disclosure, there is provided a data checking device, including: a receiving module configured to receive a transmission signal containing a first data block and transmitted by a transmission node, and the length of the first data block is N bits, the first data block is generated by a second data block, the length of which is K bits, after FEC encoding, and the second data block is generated by a third data block, the length of which is L bits, after CRC code encoding, where N, K and L are all positive integers, and N≥K>L; a determining module configured to obtain a first estimation data block of the first data block according to the transmission signal, and obtain a second estimation data block of the second data block according to the transmission signal; and a checking module configured to check the third data block according to a relationship between the first estimation data block and an FEC code space and/or a CRC check result of the second estimation data block.

In certain embodiments, the checking module includes: a first judging unit configured to judge that the third data block is received correctly when the first estimation data block is a codeword of the FEC code space and the CRC check of the second estimation data block is correct; and a second judging unit configured to judge that the third data block is not received correctly when the first estimation data block is not a codeword of the FEC code space and/or the CRC check of the second estimation data block fails.

In certain embodiments, the checking module is configured to check the third data block when the FEC code space includes the following: a set of all codewords generated using the FEC encoding manner.

According to the embodiment of the present disclosure, the technical solution of checking the received data block by comprehensively using the FEC code space and the CRC check solves the problems that a transmission rate decreases due to the fact that a CRC check code is too long and a false detection rate cannot be ensured due to the fact that the CRC check code is too short, so as to reduce the length of the CRC in the case of meeting the requirement of the system error detection rate, thereby reducing the data redundancy rate and improving the transmission efficiency.

**Brief Description of the Drawings**

The drawings are described here to provide further understanding of the present disclosure, and form a part of the present application. The schematic embodiments and description of the present disclosure are adopted to explain the present disclosure.

Fig. 1 is a schematic diagram of a digital communication system in the related art.
Fig. 2 is a schematic diagram of Turbo coding in related art.
Fig. 3 is a schematic diagram of Turbo decoding in a related art.
Fig. 4 is a schematic diagram of LDPC decoding in related art.
Fig. 5 is a flow diagram of a data checking method according to an embodiment of the present disclosure.
Fig. 6 is a structure block diagram of a data checking device according to an embodiment of the present disclosure.
Fig. 7 is another structure block diagram of a data checking device according to an embodiment of the present disclosure.
Fig. 8 is a flow diagram of a data checking method according to a exemplary embodiment of the present disclosure.
Fig. 9 is a schematic diagram of a data block of a plurality of code blocks according to a exemplary embodiment of the present disclosure.

**Detailed Description of the Embodiments**

The present disclosure is described below with reference to the drawings and the embodiments in detail. It is to be noted that the embodiments of the present application and the characteristics in certain embodiments may be combined with each other under the condition of no conflicts.

In order to make a better understanding of the present disclosure by those skilled in the art, the technical solutions In certain embodiments of the present disclosure will be described in a clear and complete manner in conjunction with the accompanying drawings In certain embodiments of the present disclosure, and it will be apparent that the described embodiments is merely a part of embodiments of the present disclosure, rather than all embodiments. All other embodiments obtained by those of ordinary skill in the art without making creative work are intended to be within the scope of the present disclosure based on embodiments of the present disclosure.

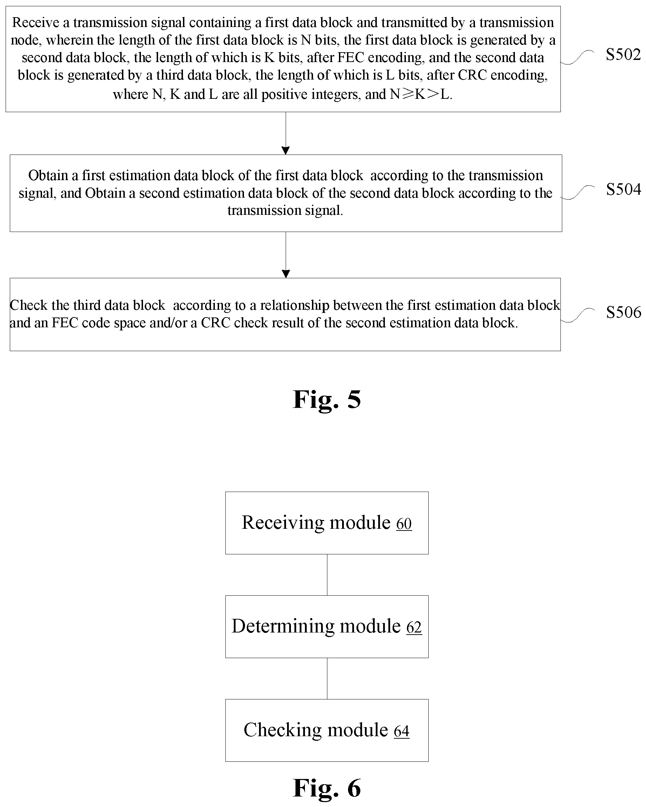

In the present embodiment, there is provided a data checking method. Fig. 5 is a flow diagram of a data checking method according to an embodiment of the present disclosure. As shown in Fig. 5, the flow includes the following steps.

At Step S502: A transmission signal containing a first data block and transmitted by a transmission node is received, and the length of the first data block is N bits, the first data block is generated by a second data block, the length of which is K bits, after FEC encoding, and the second data block is generated by a third data block, the length of which is L bits, after CRC encoding, where N, K and L are all positive integers, and $N \geq K > L$.

At Step S504: A first estimation data block of the first data block is obtained according to the transmission signal, and a second estimation data block of the second data block is obtained according to the transmission signal.

At Step S506: The third data block is checked according to a relationship between the first estimation data block and an FEC code space and/or a CRC check result of the second estimation data block.

Through the above steps, the technical solution of checking the received data block by comprehensively using the FEC code space and the CRC checks is realized, solving the problems that a transmission rate decreases due to the fact that a CRC check code is too long and a false detection rate cannot be ensured due to the fact that the CRC check code is too short, so as to reduce the length of the CRC in the case of meeting the requirement of the system error detection rate, thereby reducing the data redundancy rate and improving the transmission efficiency.

In certain embodiments of the present disclosure, there are many implementations for the above Step S506. In the exemplary embodiment of the present disclosure, there may be several following solutions: judging that the third data block is received correctly when the first estimation data block is a codeword of the FEC code space and the CRC check of the second estimation data block is correct; and judging that the third data block is not received correctly when the first estimation data block is not a codeword of the FEC code space and/or the CRC check of the second estimation data block fails. That is, as long as one of the fact that the first estimation data block is not a codeword of the FEC code space and the CRC check of the second estimation data block fails is coincident, it will be judged that the third data block is not received correctly.

In the specific implementation process, the first data block may have a plurality of cases (including a code block or a plurality of code blocks), and specifically, the first estimation data block is a codeword of the FEC code space when the first data block is a code block or a transmission block containing a code block, indicating that: the code block or the transmission block is a codeword in the FEC code space; or the first estimation data block is a codeword of the FEC code space when the first data block is a transmission block containing a plurality of data blocks, indicating that: the plurality of data blocks are codewords in the FEC code space.

Herein when it is judged that the third data block is received correctly, ACK information is transmitted to the transmission node; and when it is judged that the third data block is not received correctly, NACK information is transmitted to the transmission node.

In the above technical solution, when it is judged whether the data block is a codeword in the code space, there are a plurality of different implementations contained in the FEC encoding, which will be detailed below. The FEC encoding includes at least one of: a Turbo code, a LDPC code, and a convolution code.

(1) When the FEC code is a Turbo code, when the FEC encoding is a Turbo code, it is determined whether the data block is a codeword in the FEC code space by at least one of the following manners, and the following manners one to seven can be arbitrarily combined.

Manner one:

Comparing side information $\Lambda_i^{e_1}$ corresponding to K bits output by a first component decoder after the jth iteration with the first threshold $Y_1$, respectively, and if $\Lambda_i^{e_1} \geq Y_1$, the bit i is judged to be "1 ", if $\Lambda_i^{e_1} < Y_1$, the bit i is judged to be 0, and generating the bit sequence $E_1$ according to the judging result, where i is an integer and i $\in$ {0,1,2,... K-1}, j is an integer greater than or equal to 1, and $e_1$ represents that the $\Lambda_i^{e_1}$ is the side information output by the first component decoder.

Comparing side information $\Lambda_i^{e_2}$ corresponding to K bits output by a second component decoder in the jth iteration with the first threshold $Y_1$, respectively, and if $\Lambda_i^{e_2} \geq Y_1$, the bit i is judged to be "1 ", if $\Lambda_i^{e_2} < Y_1$, the bit i is judged to be 0, and generating the bit sequence $E_2$ according to the judging result, where $e_2$ represents that the $\Lambda_i^{e_2}$ is the side information output by the second component decoder.

Interleaving the bit sequence $E_1$ using an inner interleaver pattern of the Turbo code, generating an in-

terleaved bit sequence $E_1^{int}$, and comparing the size relationship between $E_1^{int}$ and $E_2$, and if the $E_1^{int} = E_2$, the data block generated by being decoded by the Turbo code after j iterations is a codeword in the FEC code space; if $E_1^{int} \neq E_2$, the data block generated after j iterations is not a codeword in the FEC code space, where int represents that the $E_1^{int}$ is the interleaved information or bit sequence; or

Deinterleaving the $E_2$ using an inner interleaver of the Turbo code, generating an deinterleaved bit sequence $E_2^{dei}$, and comparing $E_1$ and $E_2^{dei}$, and if the $E_2^{dei} = E_1$, the data block generated by being encoded by the Turbo code after j iterations is a codeword in the FEC code space; if $E_2^{dei} \neq E_1$, the data block generated after j iterations is not a codeword in the FEC code space, where die represents that the $E_2^{dei}$ is the deinterleaved information or bit sequence.

Manner two:

comparing the symbol $\mathrm{sign}(\Lambda_i^j)$ of soft information of K bits output by the Turbo code decoder after the jth iteration with the soft information $\mathrm{sign}(\Lambda_i^{j-1})$ output by a decoder after the j-1th iteration, and if $\mathrm{sign}(\Lambda_i^j)$ and $\mathrm{sign}(\Lambda_i^{j-1})$ of each bit are the same, the data block generated by the Turbo code decoder after the jth iteration is a codeword in the FEC code space; and if $\mathrm{sign}(\Lambda_i^j)$ and $\mathrm{sign}(\Lambda_i^{j-1})$ of at least one bit are different, the data block generated by the Turbo code decoder after the jth iteration is not a codeword in the FEC code space, where i is an integer and i $\in$ {0,1,2,... K-1}, j is an integer greater than or equal to 2.

Manner three:

comparing the symbol $\mathrm{sign}(\Lambda_i^j)$ of soft information of K bits output by the Turbo code decoder after the jth iteration with the soft information $\mathrm{sign}(\Lambda_i^{j-1})$ output by a decoder after the j-1th iteration, and if the number of bits in which $\mathrm{sign}(\Lambda_i^j)$ and $\mathrm{sign}(\Lambda_i^{j-1})$ are the same is less than or equal to a second threshold $Y_2$, the data block generated after the jth iteration is not a codeword in the FEC code space, where i is an integer and i $\in$ {0,1,2,... K-1}, j is an integer greater than or equal to 2; or

if the number of bits in which $\mathrm{sign}(\Lambda_i^j)$ and $\mathrm{sign}(\Lambda_i^{j-1})$ are different is less than or equal to a third threshold $Y_3$, the data block generated by the Turbo code decoder after the jth iteration is a codeword in the FEC code space; and if the number of

bits in which $\text{sign}(\Lambda_i^j)$ and $\text{sign}(\Lambda_i^{j-1})$ are different is greater than the third threshold $Y_3$, the data block generated after the jth iteration is not a codeword in the FEC code space.

Manner four:

comparing the symbol $\text{sign}(\Lambda_i^{a_2})$ of priori information of K bits input to a second component decoder in the jth iteration and the symbol $\text{sign}(\Lambda_i^{e_2})$ of side information of K bits output by a second component decoder in the jth iteration, and if the number of bits in which $\text{sign}(\Lambda_i^{a_2})$ and $\text{sign}(\Lambda_i^{e_2})$ are the same is less than or equal to a fourth threshold $Y_4$, the data block generated by the Turbo code decoder after the jth iteration is a codeword in the FEC code space, where i is an integer and $i \in \{0,1,2,... K-1\}$, j is an integer greater than or equal to 2, where a2 represents that the $\text{sign}(\Lambda_i^{a_2})$ is priori information input to the second component decodern; or if the number of bits in which $\text{sign}(\Lambda_i^{a_2})$ and $\text{sign}(\Lambda_i^{e_2})$ are different is less than or equal to a fifth threshold $Y_5$, the data block generated by the Turbo code decoder after the jth iteration is a codeword in the FEC code space; and if the number of bits in which $\text{sign}(\Lambda_i^{a_2})$ and $\text{sign}(\Lambda_i^{e_2})$ are different is greater than the fifth threshold $Y_5$, the data block generated after the jth iteration is not a codeword in the FEC code space.

Manner five:

comparing the absolute value $\left|\Lambda_i^j\right|$ of the soft information of K bits output by the Turbo code decoder after the jth iteration with a sixth threshold $Y_6$, and if the maximum value in $\left|\Lambda_i^j\right|$ is greater than the sixth threshold $Y_6$, the data block generated by the Turbo code decoder after the jth iteration is a codeword in the FEC code space; and if the minimum value in $\left|\Lambda_i^j\right|$ is less than or equal to the sixth threshold $Y_6$, the data block generated by the Turbo code decoder after the jth iteration is not a codeword in the FEC code space, where i is an integer and $i \in \{0,1,2,... K-1\}$, j is an integer greater than or equal to 1.

Manner six:

comparing the mean value $S^j = \dfrac{1}{K}\sum_{i=1}^{k}\left|\Lambda_i^j\right|$ of the absolute value of the soft information of K bits output by the Turbo code decoder after the jth iteration with a seventh threshold $Y_7$, and if $S^j$ is greater than the seventh threshold $Y_7$, the data block generated by the Turbo code decoder after the jth iteration is a codeword in the FEC code space; and if $S^j$ is less than or equal to the seventh threshold $Y_7$, the data block generated by the Turbo code decoder after the jth iteration is not a codeword in the FEC code space, where i is an integer and $i \in \{0,1,2,... K-1\}$, j is an integer greater than or equal to 1.

Manner seven:

comparing the sum $S^j = \sum_{i=1}^{k}\left|\Lambda_i^j\right|$ of the absolute value of the soft information of K bits output by the Turbo code decoder after the jth iteration with the sum $S^{j-1} = \sum_{i=1}^{k}\left|\Lambda_i^{j+1}\right|$ of the absolute value of the soft information of K bits output by the Turbo code decoder after the j-1th iteration, and if $S^j$ is less than or equal to $S^{j-1}$, the data block generated by the Turbo code decoder after the jth iteration is a codeword in the FEC code space; and if $S^j$ is greater than $S^{j-1}$, the data block generated by the Turbo code decoder after the jth iteration is not a codeword in the FEC code space, where i is an integer and $i \in \{0,1,2,... K-1\}$, j is an integer greater than or equal to 2, and the first threshold $Y_1$ to the seventh threshold $Y_7$ are integers greater than or equal to zero.

(2) When the FEC encoding is the LDPC code, it is determined whether the data block is a codeword in the FEC code space by at least one of the following manners, and the following manners one to seven can be arbitrarily combined.

Manner one:

comparing soft information $\Lambda_i^j$ of N codeword bits output by an LDPC code decoder after the jth iteration with the eighth threshold $Y_8$, and if $\Lambda_i^j \geq Y_8$, the bit i is judged to be "1 ", if $\Lambda_i^j < Y_8$, the bit i is judged to be 0, and generating the estimation $\tilde{E}$ of the data block according to the judging result, where i is an integer and $i \in \{0,1,2,... N-1\}$, j is an integer greater than or equal to 1;
if $\tilde{E} \times H^T = 0$, $\tilde{E}$ generated by the LDPC code decoder after the jth iteration is a codeword in the FEC code space; and if $\tilde{E} \times H^T \neq 0$, the $\tilde{E}$ is not a codeword in the FEC code space, where H is a check matrix of the LDPC code.

Manner two:

comparing soft information $\Lambda_i^j$ of N codeword bits output by an LDPC code decoder after the jth iteration with the eighth threshold $Y_8$, and if $\Lambda_i^j \geq Y_8$, the bit i is judged to be "1 ", if $\Lambda_i^j < Y_8$, the bit i is judged to be 0, generating the estimation $\tilde{E}$ of the first data block according to the judging result, and generating the estimation $\tilde{F}$ of the bit sequence by taking the first K bits for the estimation $\tilde{E}$, where i is an integer and i $\in$ {0,1,2,... N-1}, j is an integer greater than or equal to 1;

generating the data block C by performing LDPC encoding on the $\tilde{F}$, and if $\tilde{E}$ = C, the $\tilde{E}$ is a codeword in the FEC code space; and if $\tilde{E} \neq C$, the $\tilde{E}$ is not a codeword in the FEC code space.

Manner three:

comparing the symbol $\text{sign}(\Lambda_i^j)$ of soft information of N codeword bits output by a LDPC code decoder after the jth iteration with the soft information $\text{sign}(\Lambda_i^{j-1})$ output by a decoder after the j-1 th iteration, and if $\text{sign}(\Lambda_i^j)$ and $\text{sign}(\Lambda_i^{j-1})$ of each bit are the same, the data block generated by the LDPC code decoder after the jth iteration is a codeword in the FEC code space; and if $\text{sign}(\Lambda_i^j)$ and $\text{sign}(\Lambda_i^{j-1})$ of at least one bit are different, the data block generated after the jth iteration is not a codeword in the FEC code space, where i is an integer and i $\in$ {0,1,2,... N-1}, j is an integer greater than or equal to 2.

Manner four:

comparing the symbol $\text{sign}(\Lambda_i^j)$ of soft information of N codeword bits output by a LDPC code decoder after the jth iteration with the soft information $\text{sign}(\Lambda_i^{j-1})$ output by a decoder after the j-1th iteration, and if the number of bits in which $\text{sign}(\Lambda_i^j)$ and $\text{sign}(\Lambda_i^{j-1})$ are the same is greater than or equal to a ninth threshold $Y_9$, the data block generated by the LDPC code decoder after the jth iteration is a codeword in the FEC code space; if the number of bits in which $\text{sign}(\Lambda_i^j)$ and $\text{sign}(\Lambda_i^{j-1})$ are different is less than or equal to the ninth threshold $Y_9$, the data block generated after the jth iteration is not a codeword in the FEC code space, where i is an integer and i $\in$ {0,1,2,... N-1}, j is an integer greater than or equal to 2; or

if the number of bits in which $\text{sign}(\Lambda_i^j)$ and $\text{sign}(\Lambda_i^{j-1})$ are different is less than or equal to a tenth threshold $Y_{10}$, the data block generated by the LDPC code decoder after the jth iteration is a codeword in the FEC code space; and if the number of bits in which $\text{sign}(\Lambda_i^j)$ and $\text{sign}(\Lambda_i^{j-1})$ are different is greater than the tenth threshold $Y_{10}$, the data block generated after the jth iteration is not a codeword in the FEC code space.

Manner five:

comparing the absolute value of the soft information of N codeword bits output by the LDPC code decoder after the jth iteration with an eleventh threshold $Y_{11}$, and if the minimum value in $\left|\Lambda_i^j\right|$ is greater than the eleventh threshold $Y_{11}$, the data block generated by the LDPC code decoder after the jth iteration is a codeword in the FEC code space; and if the minimum value in $\left|\Lambda_i^j\right|$ is less than or equal to the eleventh threshold $Y_{11}$, the data block generated by the LDPC code decoder after the jth iteration is not a codeword in the FEC code space, where i is an integer and i $\in$ {0,1,2,... N-1}, j is an integer greater than or equal to 1.

Manner six:

$$S^j = \frac{1}{N}\sum_{i=1}^{k}\left|\Lambda_i^j\right|$$

comparing the mean value $S^j = \frac{1}{N}\sum_{i=1}^{k}\left|\Lambda_i^j\right|$ of the absolute value of the soft information of N codeword bits output by the LDPC code decoder after the jth iteration with a twelfth threshold $Y_{12}$, and if $S^j$ is greater than the twelfth threshold $Y_{12}$, the data block generated by the LDPC code decoder after the jth iteration is a codeword in the FEC code space; and if $S^j$ is less than or equal to the twelfth threshold $Y_{12}$, the data block generated by the LDPC code decoder after the jth iteration is not a codeword in the FEC code space, where i is an integer and i $\in$ {0,1,2,... N-1}, j is an integer greater than or equal to 1.

Manner seven:

$$S^j = \sum_{i=1}^{k}\left|\Lambda_i^j\right|$$

comparing the sum $S^j = \sum_{i=1}^{k}\left|\Lambda_i^j\right|$ of the absolute value of the soft information of N codeword bits output by the LDPC code decoder after the jth iteration

$$S^j = \sum_{i=1}^{k}\left|\Lambda_i^{j-1}\right|$$

with the sum $S^j = \sum_{i=1}^{k}\left|\Lambda_i^{j-1}\right|$ of the absolute value of the soft information of N codeword bits output by the LDPC code decoder after the j-1th iteration, and if $S^j$ is less than or equal to $S^{j-1}$, the data block generated by the LDPC code decoder after the jth iteration is a codeword in the FEC code space; and if $S^j$ is greater than $S^{j-1}$, the data block generated by the LDPC code decoder after the jth iteration is not a codeword in the FEC code space, where i is an integer and i $\in$ {0,1,2,... N-1}, j is an integer greater than or equal to 2, and the eighth threshold $Y_8$ to the twelfth threshold $Y_{12}$ are integers greater than or equal to zero.

(3) When the FEC encoding is the convolution code, it is determined whether the data block is a codeword in the FEC code space by at least one of the following manners, and the following manners one to five can be arbitrarily combined.

Manner one:

comparing the symbol $\text{sign}(\Lambda_i^j)$ of soft information of K bits output by the convolution code decoder after the jth iteration with the soft information $\text{sign}(\Lambda_i^{j-1})$ output by a decoder after the j-1th iteration, and if $\text{sign}(\Lambda_i^j)$ and $\text{sign}(\Lambda_i^{j-1})$ of each bit are the same, the data block generated by the convolution code decoder after the jth iteration is a codeword in the FEC code space; and if $\text{sign}(\Lambda_i^j)$ and $\text{sign}(\Lambda_i^{j-1})$ of at least one bit are different, the data block generated after the jth iteration is not a codeword in the FEC code space, where i is an integer and i $\in$ {0,1,2,... K-1}, j is an integer greater than or equal to 2.

Manner two:

comparing the symbol $\text{sign}(\Lambda_i^j)$ of soft information of K bits output by the convolution code decoder after the jth iteration with the soft information $\text{sign}(\Lambda_i^{j-1})$ output by a decoder after the j-1th iteration, and if the number of bits in which $\text{sign}(\Lambda_i^j)$ and $\text{sign}(\Lambda_i^{j-1})$ are the same is greater than or equal to a thirteenth threshold $Y_{13}$, the data block generated after the jth iteration is a codeword in the FEC code space; and if the number of bits in which $\text{sign}(\Lambda_i^j)$ and $\text{sign}(\Lambda_i^{j-1})$ are the same is less than or equal to the thirteenth threshold $Y_{13}$, the data block generated after the jth iteration is not a codeword in the FEC code space, where i is an integer and i $\in$ {0,1,2,... K-1}, j is an integer greater than or equal to 2; or

if the number of bits in which $\text{sign}(\Lambda_i^j)$ and $\text{sign}(\Lambda_i^{j-1})$ are different is greater than or equal to a fourteenth threshold $Y_{14}$, the data block generated by the convolution code decoder after the jth iteration is a codeword in the FEC code space; and if the number of bits in which $\text{sign}(\Lambda_i^j)$ and $\text{sign}(\Lambda_i^{j-1})$ are different is greater than the fourteenth threshold $Y_{14}$, the data block generated after the jth iteration is not a codeword in the FEC code space.

Manner three:

comparing the absolute value $\left|\Lambda_i^j\right|$ of the soft information of K bits output by the convolution code decoder after the jth iteration with a fifteenth threshold $Y_{15}$, and if the maximum value in $\left|\Lambda_i^j\right|$ is greater than the fifteenth threshold $Y_{15}$, the data block generated by the convolution code decoder after the jth iteration is a codeword in the FEC code space; and if the minimum value in $\left|\Lambda_i^j\right|$ is less than or equal to the fifteenth threshold $Y_{15}$, the data block generated after the jth iteration is not a codeword in the FEC code space, where i is an integer and i $\in$ {0,1,2,... K-1}, j is an integer greater than or equal to 1.

Manner four:

comparing the mean value $S^j = \frac{1}{K}\sum_{i=1}^{k}\left|\Lambda_i^j\right|$ of the absolute value of the soft information of K bits output by the convolution code decoder after the jth iteration with a sixteenth threshold $Y_{16}$, and if $S^j$ is greater than the sixteenth threshold $Y_{16}$, the data block generated by the convolution code decoder after the jth iteration is a codeword in the FEC code space; and if $S^j$ is less than or equal to the sixteenth threshold $Y_{16}$, the data block generated after the jth iteration is not a codeword in the FEC code space, where i is an integer and i $\in$ {0,1,2,... K-1}, j is an integer greater than or equal to 1.

Manner five:

comparing the sum $S^j = \sum_{i=1}^{k}\left|\Lambda_i^j\right|$ the absolute value of the soft information of K bits output by the convolution code decoder after the jth iteration with the

$$S^{j-1} = \sum_{i=1}^{k} \left| \Lambda_i^{j-1} \right|$$

sum of the absolute value of the soft information of K bits output by the LDPC code decoder after the j-1th iteration, and if $S^j$ is less than or equal to $S^{j-1}$, the data block is a codeword in the FEC code space; and if $S^j$ is greater than $S^{j-1}$, the data block is not a codeword in the FEC code space, where i is an integer and $i \in \{0,1,2,... K-1\}$, j is an integer greater than or equal to 2, and the thirteenth threshold $Y_{13}$ to the sixteenth threshold $Y_{16}$ are integers greater than or equal to zero.

In certain embodiments of the present disclosure, during the CRC encoding, it is also possible to perform a process of determining the length of the CRC according to the length L of the third data block. For the technical solution, in an example of the embodiment of the present disclosure, it be achieved by the following technical solution: dividing the range of values of the length L into T intervals in an ascending order: $L_1, L_2, ......L_T$, where each interval corresponds to the CRCs of different lengths: $L_1^{CRC}, L_2^{CRC}, ......L_T^{CRC}$, and $L_1^{CRC}, L_2^{CRC}, ......L_T^{CRC}$, and T is a positive integer; and selecting the length of the CRC used for encoding the third data block according to the value interval to which the length L of the third data block belongs.

It should be noted that the transmission node includes at least one of: a base station, a relay node, and a terminal.

(1) When the transmission node is a terminal, a transmission signaling for indicating a data checking mode is transmitted to the transmission node, and the data checking mode includes at least one of: checking data according to the FEC code space and/or the CRC check result; and checking data according to the CRC check result.

(2) When the transmission node is a base station or a relay node, an indication signaling for configuring the data checking mode and transmitted by the transmission node is received, and the data checking mode includes at least one of: checking data according to the FEC code space and/or the CRC check result; checking data according to the CRC check result.

In the actual application process, it is possible to flexibly select between the data checking method provided by the embodiment of the present disclosure and the conventional process using only the CRC check. Specifically, the technical solution provided by the embodiment of the disclosure is used in one of the following cases: a data checking mode in which data is checked according to the FEC code space and/or the CRC check result: the length of the transmission block or code block in the first data block is less than the first preset threshold; or the number of repetitions of the transmission block or code block in the first data block is greater than the second preset threshold. The determination of the first preset threshold and the second preset threshold can be flexibly set as required.

It should be noted that the FEC code space In certain embodiments of the present disclosure includes a set of all the codewords generated using the FEC encoding manner, and the main body executing the above steps may be, but is not limited to, any network elements such as a terminal, a base station, and a relay having the function of receiving data.

In the present embodiment, the process referred to in the above Step S504 obtains the first estimation data block of the first data block according to the transmission signal, which may be implemented by the following process: obtaining the first estimation data block by demodulating the transmission signal; and obtains the second estimation data block of the second data block according to the transmission signal, which may be implemented by the following process: obtaining the second estimation data block by demodulating and FEC decoding the transmission signal.

In summary, the embodiments of the present disclosure propose a data checking method of using a combination of CRC and FEC codes. The method only requires the addition of a shorter CRC to the data block, and can judge according to the characteristics of the FEC decoder whether the codeword passing the CRC check is a codeword in the FEC code space, and if so, it is judged that the data is received correctly and the ACK is fed back to the transmitting end; if not, it is judged that the data is not received correctly, and the NACK is fed back to the transmitting end.

In the present embodiment, there is also provided a data checking device for realizing the above embodiments and exemplary embodiments. Those having been described will not be described in detail. As used herein, the term "module" may implement a combination of software and/or hardware of a predetermined function. Although the device described in the following embodiments are preferably implemented in software, the implementation of hardware, or a combination of software and hardware, is also possible and conceivable.

Fig. 6 is a structure block diagram of a data checking device according to an embodiment of the present disclosure. As shown in Fig. 6, the device includes:

a receiving module 60 configured to receive a transmission signal containing a first data block and transmitted by a transmission node, and the length of the first data block is N bits, the first data block is generated by a second data block, the length of which is K bits, after FEC encoding, and the second data block is generated by a third data block, the length of which is L bits, after CRC encoding, where N, K and L are all positive integers, and N≥K>L;

a determining module 62 connected to the receiving module 60 and configured to obtain a first estimation data block of the first data block according to the transmission signal, and obtain a second estimation data block of the second data block according to the transmission signal; and

a checking module 64 connected to the determining module 62 and configured to check the third data block according to a relationship between the first estimation data block and an FEC code space and/or a CRC check result of the second estimation data block.

Through the combination of the above modules, the technical solution of checking the received data block by comprehensively using the FEC code space and the CRC checks is realized, solving the problems that a transmission rate decreases due to the fact that a CRC check code is too long and a false detection rate cannot be ensured due to the fact that the CRC check code is too short, so as to reduce the length of the CRC in the case of meeting the requirement of the system error detection rate, thereby reducing the data redundancy rate and improving the transmission efficiency.

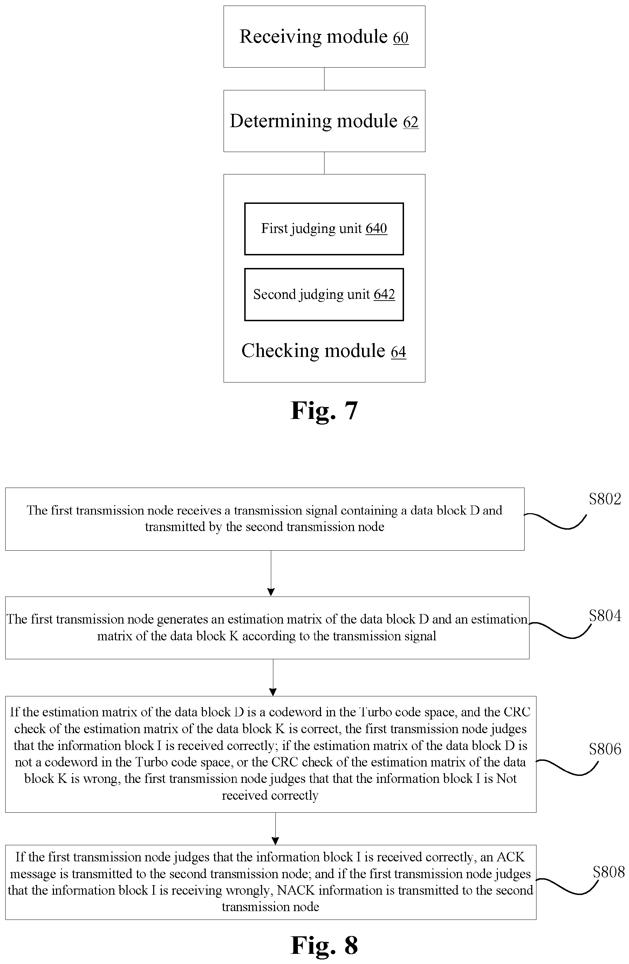

In the present embodiment, as shown in Fig. 7, in order to complete the function of the checking module 64, In certain embodiments of the present disclosure, the checking module 64 may include the following units:

a first judging unit 640 configured to judge that the third data block is received correctly when the first estimation data block is a codeword of the FEC code space and the CRC check of the second estimation data block is correct; and

a second judging unit 642 configured to judge that the third data block is not received correctly when the first estimation data block is not a codeword of the FEC code space and/or the CRC check of the second estimation data block fails.

In one example of the embodiment of the present disclosure, the checking module 64 is configured to check the third data block when the FEC code space includes the following: a set of all codewords generated using the FEC encoding manner.

In order to better understand the data checking process in the above embodiments, the following description will be made with reference to the exemplary embodiments:

Exemplary embodiment one

The present embodiment proposes a data checking method, applied to a first transmission node. As shown in Fig. 8, the method includes the following steps.

At Step S802: The first transmission node receives a transmission signal containing a data block D (equivalent to the first data block of the above embodiment) and transmitted by the second transmission node, and the length of the data block D is N bits, the data block D is generated by a data block K (equivalent to the second data block of the above embodiment), the length of which is K bits, after Turbo encoding, and the data block K is generated by a data block L, the length of which is L bits, after CRC encoding, where N, K and L are all positive integers, and N≥K>L.

Herein the first transmission node is a terminal and the second transmission node is a base station or a relay; or the first transmission node is a base station or a relay, the second transmission node is a terminal.

Herein the Turbo code space is a set of codewords generated by traversing all data blocks of the same length and by the Turbo encoder.

For example, the data block having the length of F bits has 2F codewords in the code space generated after the FEC encoding.

In the present embodiment, the first transmission node receives the transmission signal containing the data block D and transmitted by the second transmission node, indicating that the method further includes: the transmission signal including the signal after being by modulated the data block D.

In the present embodiment, the data block D may be a code block or a transmission block including only one code block, or may be a transmission block including a plurality of code blocks.

Specifically, if the data block D is a code block or a transmission block including only one code block, the transmission signal is generated by the following manners, including Step S8020 to Step S8026 (not shown).

At Step S8020: A data block I is subjected to CRC encoding, and the CRC redundancy bit is added to generate a data block K, and if the data block K is a block, the added CRC redundancy bit is a redundant bit generated by the code block CRC generation polynomial; if the data block K is a transmission block, the added CRC redundancy bit is a redundant bit generated by the transmission block CRC generation polynomial.

Herein the method further includes: determining the length of the redundant bit of the code block CRC or the transmission block CRC according to the length L of the data block I.

In the present embodiment, the range of values of the length L is divided into T intervals in an ascending order: $L_1, L_2, ...... L_T$, where each interval corresponds to the CRC redundant bits of different lengths, $L_1^{CRC}, L_2^{CRC}, ...... L_T^{CRC}$, and $L_1^{CRC}, L_2^{CRC}, ...... L_T^{CRC}$. The data block K is generated by CRC encoding the data block I with a corresponding length according to the value range to which L belongs.

At Step S8021: The data block K is subjected to the Turbo code encoding to generate a master codeword M, and the master codeword M is subjected to rate matching to generate the data block D, and the rate matching includes at least one of interleaving the master codeword M, and deleting or repeating the master codeword according to the transmission code rate.

At Step S8022: The data containing the data block D is modulated to generate the transmission signal, and the modulation includes at least one of: performing digital baseband modulation of the data containing the data block D to generate a modulation symbol; performing Multiple-Input Multiple-Output (MIMO) precoding on the modulation symbol; mapping the modulation symbol to a corresponding physical channel resource to generate a baseband signal; and converting the baseband signal into a radio frequency signal.

Herein the digital baseband modulation includes at least one of the following modulation modes: Binary Phase Shift Key (BPSK), Quadrature Phase Shift Keying (QPSK), 16 Quadrature Amplitude Modulation (QAM), 32QAM, 64QAM, 256QAM, 512QAM, and 1024QAM.

Specifically, if the data block D is a transmission block containing a plurality of code blocks, the transmission signal is generated in the following manner.

At Step S8023: The data block I is subjected to transmission block CRC encoding, the transmission block CRC redundancy bit is added, and the data block I is generated.

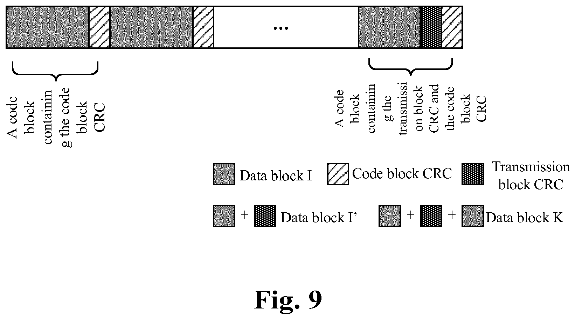

At Step S8024: The code block I is subjected to code block division to generate a plurality of code blocks, each of the code blocks is subjected to the code block CRC encoding, and the code block CRC redundancy bit is added; and the data block K contains the data block I and the added transmission block CRC and the code block CRC, as shown in Fig. 9, the data block K containing a plurality of code blocks in Fig. 9.

Herein the method further includes determining the length of the redundant bits of the transmission block CRC according to the length L of the data block I.

In the present embodiment, the range of values of the length L is divided into T intervals in an ascending order: $L_1, L_2, \ldots L_T$, where each interval corresponds to the CRC redundant bits of different lengths, $L_1^{CRC}, L_2^{CRC}, \ldots L_T^{CRC}$, and $L_1^{CRC}, L_2^{CRC}, \ldots L_T^{CRC}$. The data block K is generated by CRC encoding the data block I with a corresponding length according to the value range to which L belongs.

Herein the method further includes determining the length of the redundant bits of the code block CRC by the length L' of each code block after the code block division is performed according to the data block I.

In the present embodiment, the range of values of the length L' is divided into T intervals in an ascending order: $L'_1, L'_2, \ldots L'_T$, where each interval corresponds to the CRC redundant bits of different lengths, $L_1^{'CRC}, L_2^{'CRC}, \ldots L_T^{'CRC}$, and $L_1^{'CRC}, L_2^{'CRC}, \ldots L_T^{'CRC}$. The data block is subjected to CRC encoding with a corresponding length according to the value range to which L' belongs.

At Step S8025: The data block K is subjected to the Turbo code encoding, and a plurality of code blocks (including a code block CRC and a transmission block CRC) in the data block K are respectively encoded to generate a master codeword of each code bloc. The master codeword is subjected to rate matching and code block concatenation to generate the data block K, and the rate matching includes at least one of: interleaving the master codeword; deleting or repeating the master codeword according to the transmission rate or the available physical channel resources and the modulation mode;

At Step S8026: The data containing the data block D is modulated to generate the transmission signal, and the modulation includes at least one of: performing digital baseband modulation of the data containing the data block D to generate a modulation symbol; performing MIMO precoding on the modulation symbol; mapping the modulation symbol to a corresponding physical channel resource and generating a time domain baseband signal; and converting the time domain baseband signal into a radio frequency signal.

Herein the digital baseband modulation includes at least one of the following modulation modes: BPSK, QPSK, 16QAM, 32QAM, 64QAM, 256QAM, 512QAM, and 1024QAM.

At Step S804: The first transmission node generates estimation $D$ (equivalent to the first estimation matrix of the above embodiment, and the estimation matrix of the data block represents the estimation $D$ in Fig. 8) of the data block D and estimation $\tilde{K}$ (equivalent to the second estimation matrix of the above embodiment, and the estimation matrix of the data block K represents the estimation $\tilde{K}$ in Fig. 8) of the data block K according to the transmission signal.

Herein the first transmission node demodulates the received transmission signal to generate estimation $D$ of the data block D; and the demodulation includes at least one of converting the radio frequency signal into a time domain baseband signal; extracting a modulation symbol from the time domain baseband signal; performing a demodulation MIMO on the modulation symbol; and performing digital baseband demodulation on the modulation symbol.

If the data block D is a block or a transmission block including only one code block, the first transmission node demodulates the received transmission signal and the Turbo decoder generates estimation $\tilde{K}$ of the data block D.

In the present embodiment, if the data block D is a transmission block including a plurality of code blocks, the first transmission node demodulates the received transmission signal and performs Turbo decoding on each code block after performing code block division on the demodulated soft bits, respectively, to generate estimation $\tilde{K}$ of the data block K.

At Step S806: If the $D$ is a codeword in the Turbo code space, and the CRC check of *the* $\tilde{K}$ is correct, the first transmission node judges that the information block I is received correctly; if the $D$ is not a codeword in the Turbo code space, or the CRC check of *the* $\tilde{K}$ is wrong, the first transmission node judges that that the information block I is not received correctly.

Herein if the data block D is a code block or a transmission block including only one code block, the $D$ is a codeword in the code space, indicating that: the code block or the transmission block is a codeword in the Turbo code space.

Herein if the D is a transmission block including a plurality of code blocks, the $D$ is a codeword in the code space, indicating that: all of the code blocks in the $D$ are codewords in the Turbo code space.

In certain embodiment, it is determined that the data block (a code block or transmission block) in the $D$ is a codeword in the code space by at least one of the following manners or any combination thereof.

Manner one:

comparing side information $\Lambda_i^{e_1}$ corresponding to K bits output by a first component decoder after the jth iteration with the first threshold $Y_1$, respectively, and if $\Lambda_i^{e_1} \geq Y_1$, the bit i is judged to be "1 ", if $\Lambda_i^{e_1} < Y_1$, the bit i is judged to be 0, and generating the bit sequence $E_1$ according to the judging result, where i is an integer and i $\in$ {0,1,2,... K-1}, j is an integer greater than or equal to 1, and $e_1$ represents that the $\Lambda_i^{e_1}$ is the side information output by the first component decoder;

comparing side information $\Lambda_i^{e_2}$ corresponding to K bits output by a second component decoder in the jth iteration with the first threshold $Y_1$, respectively, and if $\Lambda_i^{e_2} \geq Y_1$, the bit i is judged to be "1 ", if $\Lambda_i^{e_2} < Y_1$, the bit i is judged to be 0, and generating the bit sequence $E_2$ according to the judging result, where $e_2$ represents that the $\Lambda_i^{e_2}$ is the side information output by the second component decoder; interleaving the bit sequence $E_1$ using an inner interleaver pattern of the Turbo code, generating an interleaved bit sequence $E_1^{int}$, and comparing the size relationship between $E_1^{int}$ and $E_2$, and if the $E_1^{int}$= $E_2$, the data block generated by being decoded by the Turbo code after j iterations is a codeword in the FEC code space; if $E_1^{int} \neq E_2$, the data block

generated after j iterations is not a codeword in the FEC code space, where int represents that the $E_1^{int}$ is the interleaved information or bit sequence; or deinterleaving the $E_2$ using an inner interleaver of the Turbo code, generating an deinterleaved bit sequence $E_2^{dei}$, and comparing $E_1$ and $E_2^{dei}$, and if the $E_2^{dei} = E_1$, the data block generated by being encoded by the Turbo code after j iterations is a codeword in the FEC code space; if $E_2^{dei} \neq E_1$, the data block generated after j iterations is not a codeword in the FEC code space, where die represents that the $E_2^{dei}$ is the deinterleaved information or bit sequence.

Manner two:

comparing the symbol $\text{sign}(\Lambda_i^j)$ soft information of K bits output by the Turbo code decoder after the jth iteration with the soft information $\text{sign}(\Lambda_i^{j-1})$ output by a decoder after the j-1 th iteration, and if $\text{sign}(\Lambda_i^j)$ and $\text{sign}(\Lambda_i^{j-1})$ of each bit are the same, the data block generated by the Turbo code decoder after the jth iteration is a codeword in the FEC code space; and if $\text{sign}(\Lambda_i^j)$ and $\text{sign}(\Lambda_i^{j-1})$ of at least one bit are different, the data block generated by the Turbo code decoder after the jth iteration is not a codeword in the FEC code space, where i is an integer and i $\in$ {0,1,2,... K-1}, j is an integer greater than or equal to 2.

Manner three:

comparing the symbol $\text{sign}(\Lambda_i^j)$ of soft information of K bits output by the Turbo code decoder after the jth iteration with the soft information $\text{sign}(\Lambda_i^{j-1})$ output by a decoder after the j-1th iteration, and if the number of bits in which $\text{sign}(\Lambda_i^j)$ and $\text{sign}(\Lambda_i^{j-1})$ are the same is less than or equal to a second threshold $Y_2$, the data block generated after the jth iteration is not a codeword in the FEC code space, where i is an integer and i $\in$ {0,1,2,... K-1}, j is an integer greater than or equal to 2; or if the number of bits in which $\text{sign}(\Lambda_i^j)$ and $\text{sign}(\Lambda_i^{j-1})$ are different is less than or equal to a third threshold $Y_3$, the data block generated by the Turbo code decoder after the jth iteration is a codeword in the FEC code space; and if the number of bits in which $\text{sign}(\Lambda_i^j)$ and $\text{sign}(\Lambda_i^{j-1})$ are different is greater than the third threshold $Y_3$, the data block generated after the jth iteration is not a codeword in the FEC code space.

Manner four:

comparing the symbol $\text{sign}(\Lambda_i^{a_2})$ of priori information of K bits input to a second component decoder in the jth iteration and the symbol $\text{sign}(\Lambda_i^{e_2})$ of side information of K bits output by a second component decoder in the jth iteration, and if the number of bits in which $\text{sign}(\Lambda_i^{a_2})$ and $\text{sign}(\Lambda_i^{e_2})$ are the same is less than or equal to a fourth threshold $Y_4$, the data block generated by the Turbo code decoder after the jth iteration is a codeword in the FEC code space, where i is an integer and i ∈ {0,1,2,... K-1}, j is an integer greater than or equal to 2, where a2 represents that the $\text{sign}(\Lambda_i^{a_2})$ is priori information input to the second component decoder; or

if the number of bits in which $\text{sign}(\Lambda_i^{a_2})$ and $\text{sign}(\Lambda_i^{e_2})$ are different is less than or equal to a fifth threshold $Y_5$, the data block generated by the Turbo code decoder after the jth iteration is a codeword in the FEC code space; and if the number of bits in which $\text{sign}(\Lambda_i^{a_2})$ and $\text{sign}(\Lambda_i^{e_2})$ are different is greater than the fifth threshold $Y_5$, the data block generated after the jth iteration is not a codeword in the FEC code space.

Manner five:

comparing the absolute value $\left|\Lambda_i^j\right|$ of the soft information of K bits output by the Turbo code decoder after the jth iteration with a sixth threshold $Y_6$, and if the maximum value in $\left|\Lambda_i^j\right|$ is greater than the sixth threshold $Y_6$, the data block generated by the Turbo code decoder after the jth iteration is a codeword in the FEC code space; and if the minimum value in $\left|\Lambda_i^j\right|$ is less than or equal to the sixth threshold $Y_6$, the data block generated by the Turbo code decoder after the jth iteration is not a codeword in the FEC code space, where i is an integer and i ∈ {0,1,2,... K-1}, j is an integer greater than or equal to 1.

Manner six:

comparing the mean value $S^j = \frac{1}{K}\sum_{i=1}^{k}\left|\Lambda_i^j\right|$ of the absolute value of the soft information of K bits output by the Turbo code decoder after the jth iteration with a seventh threshold $Y_7$, and if $S^j$ is greater than the seventh threshold $Y_7$, the data block generated by the Turbo code decoder after the jth iteration is a codeword in the FEC code space; and if $S^j$ is less than or equal to the seventh threshold $Y_7$, the data block generated by the Turbo code decoder after the jth iteration is not a codeword in the FEC code space, where i is an integer and i ∈ {0,1,2,... K-1}, j is an integer greater than or equal to 1.

Manner seven:

comparing the sum $S^j = \sum_{i=1}^{k}\left|\Lambda_i^j\right|$ of the absolute value of the soft information of K bits output by the Turbo code decoder after the jth iteration with the sum $S^{j-1} = \sum_{i=1}^{k}\left|\Lambda_i^{j+1}\right|$ of the absolute value of the soft information of K bits output by the Turbo code decoder after the j-1th iteration, and if $S^j$ is less than or equal to $S^{j-1}$, the data block generated by the Turbo code decoder after the jth iteration is a codeword in the FEC code space; and if $S^j$ is greater than $S^{j-1}$, the data block generated by the Turbo code decoder after the jth iteration is not a codeword in the FEC code space, where i is an integer and i ∈ {0,1,2,... K-1}, j is an integer greater than or equal to 2, and the first threshold $Y_1$ to the seventh threshold $Y_7$ are integers greater than or equal to zero, and the first threshold $Y_1$ to the seventh threshold $Y_7$ may be equal or partially equal, or may be completely unequal.

Herein the CRC check of $\tilde{K}$ is correct or wrong, indicating that the method includes that:

if the data block D is a code block or a transmission block containing only one code block, the $\tilde{K}$ is subjected to the code block CRC or the transmission block CRC check, and if the code block CRC or the transmission block CRC check is passed, the CRC check of the $\tilde{K}$ is correct, otherwise, the CRC check of the $\tilde{K}$ is wrong; and
if the data block D is a transmission block including a plurality of code blocks, if the following conditions are satisfied at the same time, the CRC check of the $\tilde{K}$ is correct, otherwise, the CRC check of the $\tilde{K}$ is wrong.

Condition 1: In the $\tilde{K}$, the code block CRC checks of all the code blocks are passed.
Condition 2: In the $\tilde{K}$, after the CRC of each code block is removed, the estimation $\tilde{I}'$ of the data block I' is obtained, and the transmission block CRC check of $\tilde{I}'$ is passed.
In the present embodiment, the method further includes the following steps.
At Step S808: If the first transmission node judges that the information block I is received correctly, an ACK message is transmitted to the second transmission node; and if the first transmission node judges that the information block I is not received correctly, NACK information is transmitted to the second transmission node.

In certain embodiments, the method further includes the following steps.

At Step S808-1: When the first transmission node is a terminal and the second transmission node is a base station (or relay); or when the first transmission node is a base station (or relay) and the second transmission node is a terminal, the method further includes that:

the terminal receives an indication signaling for configuring the data checking mode and transmitted by the base station (or relay), and the data checking mode includes at least one of: the data checking method as described in Step 103, or the data checking method based on CRC.

In certain embodiments, the method further includes:

At Step S808-2: When the first transmission node is a terminal and the second transmission node is a base station (or relay); or when the first transmission node is a base station (or relay) and the second transmission node is a terminal, the method further includes that:

the terminal receives an indication signaling for configuring the data checking mode and transmitted by the base station (or relay), and the data checking mode includes at least one of: the data checking method as described in Step 103, or the data checking method based on CRC.

In certain embodiments, the method further includes the following steps.

At Step S808-3: If the length of the transmission block or code block in the data block D is smaller than the preset threshold value Z1 (bit) or the number of repetitions of the transmission block or code block in the data block D is greater than the preset threshold value Z2, the first transmission node performs data checking using the data checking method described in Step S806, otherwise, the first transmission node uses the manner of CRC to perform data checking.

Example 1:

In the MTC application, the base station receives the transmission signal containing the data block D and transmitted by the terminal, the length of the data block D is 1536 bits, and the data block D includes only one code block. The data block D is generated by the data block K of 768 bit after Turbo encoding, and the Turbo encoder first encodes the master codeword having a length of 2316 bits, and then, performs rate matching operation on the master codeword such as deleting according to the transmission code rate of 1/2 to obtain the data block D having a length of 1536 bits,

Herein the data block K is obtained by a transmission block I with a length of 760 bits after a transmission block CRC encoding of 8 bits.

Herein the transmission signal received by the base station is a signal transmitted by the terminal after the data block D has been modulated.

The base station demodulates the received transmission signal to obtain the estimation $D$ of the data block D, inputs the $D$ to the Turbo code decoder, and determines the D is a codeword in the code space in the following manner:

comparing side information $\Lambda_i^{e_1}$ corresponding to K bits output by a first component decoder after the jth iteration with the first threshold $Y_1=0$, respectively, and if $\Lambda_i^{e_1} \geq Y_1$, the bit i is judged to be "1 ", if $\Lambda_i^{e_1} < Y_1$, the bit i is judged to be 0, and generating the bit sequence $E_1$ according to the judging result, where i is an integer and i $\in$ {0,1,2,... K-1}, j is an integer greater than or equal to 1, and $e_1$ represents that the $\Lambda_i^{e_1}$ is the side information output by the first component decoder;

comparing side information $\Lambda_i^{e_2}$ corresponding to K bits output by a second component decoder in the jth iteration with the first threshold $Y_1=0$, respectively, and if $\Lambda_i^{e_2} \geq Y_1$, the bit i is judged to be "1 ", if $\Lambda_i^{e_2} < Y_1$, the bit i is judged to be 0, and generating the bit sequence $E_2$ according to the judging result, where $e_2$ represents that the $\Lambda_i^{e_2}$ is the side information output by the second component decoder;

interleaving the bit sequence $E_1$ using an inner interleaver pattern of the Turbo code, generating an interleaved bit sequence $E_1^{int}$, and comparing the size relationship between $E_1^{int}$ and $E_2$, and if the $E_1^{int} = E_2$, the data block generated by being decoded by the Turbo code after j iterations is a codeword in the FEC code space; if $E_1^{int} \neq E_2$, the data block generated after j iterations is not a codeword in the FEC code space, where int represents that the $E_1^{int}$ is the interleaved information or bit sequence; or deinterleaving the $E_2$ using an inner interleaver of the Turbo code, generating an deinterleaved bit sequence $E_2^{dei}$, and comparing $E_1$ and $E_2^{dei}$, and if the $E_2^{dei} = E_1$, the data block generated by being encoded by the Turbo code after j iterations is a codeword in the FEC code space; if $E_2^{dei} \neq E_1$, the data block generated after j iterations is not a codeword in the FEC code space, where die represents that the $E_2^{dei}$ is the deinterleaved information or bit sequence.

If the D is not a codeword in the code space, the base station judges that the transmission block I is not received correctly.

If the *D* is a codeword in the code space, the estimation $\tilde{K}$ of the data block K obtained by the Turbo code after j iterations is subjected to the transmission block CRC checking of 8 bits; if the check is passed, the base station judges that the transmission block I is received correctly; otherwise, the base station judges that the transmission block I is not received correctly.

In the present embodiment, if the base station judges that the transmission block I is received correctly, the base station feeds back the ACK to the terminal; if the base station judges that the transmission block I is not received correctly, the base station feeds back the NACK to the terminal.

Example 2:

The difference between Example 2 and Example 1 is that the terminal receives the transmission signal containing the data block D and transmitted by the base station and if the terminal also receives the indication signaling transmitted by the base station, the indication signaling is used to configure the data checking mode of the data block D. If the signaling indicates a data checking method of combining CRC and FEC is used, the terminal uses the same data checking method as Example 1; otherwise, the terminal still uses the conventional CRC data checking method.

Example 3:

The difference between Example 3 and Example 1 is that the base station determines the data checking method according to the size of the transmission block transmitted by the terminal or the number of repetitions of the transmission block. Specifically, when the length of the transmission block is smaller than a preset threshold value Z1 or the number of repetitions of the transmission block or code block is greater than the preset threshold value Z2, the base station uses the same data checking method as Example 1; otherwise, the base station still employs a conventional CRC data checking method.

Example 4:

The difference between Example 4 and Example 1 is that the base station also transmits an indication signaling to the terminal about the data checking mode, and the checking mode at least includes indicating that the data checking method is a data checking method in Example or a conventional CRC data checking method.

The exemplary embodiment of the present disclosure achieves the following technical effects: in the LTE system, transmissions block I, which normally has a length of 760 bits, and needs to add a 24-bit CRC. As can be seen in Example 1, the transmission block I only add an 8-bit CRC, but by means of the code space detecting method, it is possible to overcome the case that the false detection rate is increased due to the shorter CRC. Therefore, according to the method of the present disclosure, it is possible to reduce the CRC length of the data block and improve the transmission efficiency.

Exemplary embodiment two:

The difference between the exemplary embodiment two and the exemplary embodiment one is that, in the exemplary embodiment two, the FEC is an LDPC code.

Step S805: It is determined that the data block (a code block or transmission block) in $\tilde{D}$ is a codeword in the code space by at least one of the following manners one to seven or any combination thereof.

Manner one:

comparing soft information $\Lambda_i^j$ of N codeword bits output by an LDPC code decoder after the jth iteration with the eighth threshold $Y_8$, and if $\Lambda_i^j \geq Y_8$, the bit i is judged to be "1", if $\Lambda_i^j < Y_8$, the bit i is judged to be 0, and generating the estimation $\tilde{E}$ of the data block according to the judging result, where i is an integer and $i \in \{0,1,2,... N-1\}$, j is an integer greater than or equal to 1;

if $\tilde{E} \times H^T = 0$, $\tilde{E}$ generated by the LDPC code decoder after the jth iteration is a codeword in the FEC code space; and if $\tilde{E} \times H^T \neq 0$, the $\tilde{E}$ is not a codeword in the FEC code space, where H is a check matrix of the LDPC code.

Manner two:

comparing soft information $\Lambda_i^j$ of N codeword bits output by an LDPC code decoder after the jth iteration with the eighth threshold $Y_8$, and if $\Lambda_i^j \geq Y_8$, the bit i is judged to be "1", if $\Lambda_i^j < Y_8$, the bit i is judged to be 0, generating the estimation $\tilde{E}$ of the first data block according to the judging result, and generating the estimation $\tilde{F}$ of the bit sequence by taking the first K bits for the estimation $\tilde{E}$, where i is an integer and $i \in \{0,1,2,... N-1\}$, j is an integer greater than or equal to 1;

generating the data block C by performing LDPC encoding on the $\tilde{F}$, and if $\tilde{E} = C$, the $\tilde{E}$ is a codeword in the FEC code space; and if $\tilde{E} \neq C$, the $\tilde{E}$ is not a codeword in the FEC code space.

Manner three:

comparing the symbol $\text{sign}(\Lambda_i^j)$ of soft information of N codeword bits output by a LDPC code decoder after the jth iteration with the soft information

$\text{sign}(\Lambda_i^{j-1})$ output by a decoder after the j-1th iteration, and if $\text{sign}(\Lambda_i^{j})$ and $\text{sign}(\Lambda_i^{j-1})$ of each bit are the same, the data block generated by the LDPC code decoder after the jth iteration is a codeword in the FEC code space; and if $\text{sign}(\Lambda_i^{j})$ and $\text{sign}(\Lambda_i^{j-1})$ of at least one bit are different, the data block generated after the jth iteration is not a codeword in the FEC code space, where i is an integer and i $\in$ {0,1,2,... N-1}, j is an integer greater than or equal to 2.

Manner four:

comparing the symbol $\text{sign}(\Lambda_i^{j})$ of soft information of N codeword bits output by a LDPC code decoder after the jth iteration with the soft information $\text{sign}(\Lambda_i^{j-1})$ output by a decoder after the j-1th iteration, and if the number of bits in which $\text{sign}(\Lambda_i^{j})$ and $\text{sign}(\Lambda_i^{j-1})$ are the same is greater than or equal to a ninth threshold $Y_9$, the data block generated by the LDPC code decoder after the jth iteration is a codeword in the FEC code space; if the number of bits in which $\text{sign}(\Lambda_i^{j})$ and $\text{sign}(\Lambda_i^{j-1})$ are different is less than or equal to the ninth threshold $Y_9$, the data block generated after the jth iteration is not a codeword in the FEC code space, where i is an integer and i $\in$ {0,1,2,... N-1}, j is an integer greater than or equal to 2; or

if the number of bits in which $\text{sign}(\Lambda_i^{j})$ and $\text{sign}(\Lambda_i^{j-1})$ are different is less than or equal to a tenth threshold $Y_{10}$, the data block generated by the LDPC code decoder after the jth iteration is a codeword in the FEC code space; and if the number of bits in which $\text{sign}(\Lambda_i^{j})$ and $\text{sign}(\Lambda_i^{j-1})$ are different is greater than the tenth threshold $Y_{10}$, the data block generated after the jth iteration is not a codeword in the FEC code space.

Manner five:

comparing the absolute value of the soft information of N codeword bits output by the LDPC code decoder after the jth iteration with an eleventh threshold $Y_{11}$, and if the minimum value in $\left|\Lambda_i^{j}\right|$ is greater than the eleventh threshold $Y_{11}$, the data block generated by the LDPC code decoder after the jth iteration is a codeword in the FEC code space; and if the minimum

value in $\left|\Lambda_i^{j}\right|$ is less than or equal to the eleventh threshold $Y_{11}$, the data block generated by the LDPC code decoder after the jth iteration is not a codeword in the FEC code space, where i is an integer and i $\in$ {0,1,2,... N-1}, j is an integer greater than or equal to 1.

Manner six:

$$S^j = \frac{1}{N}\sum_{i=1}^{k}\left|\Lambda_i^{j}\right|$$

comparing the mean value of the absolute value of the soft information of N codeword bits output by the LDPC code decoder after the jth iteration with a twelfth threshold $Y_{12}$, and if $S^j$ is greater than the twelfth threshold $Y_{12}$, the data block generated by the LDPC code decoder after the jth iteration is a codeword in the FEC code space; and if $S^j$ is less than or equal to the twelfth threshold $Y_{12}$, the data block generated by the LDPC code decoder after the jth iteration is not a codeword in the FEC code space, where i is an integer and i $\in$ {0,1,2,... N-1}, j is an integer greater than or equal to 1.

Manner seven:

$$S^j = \sum_{i=1}^{k}\left|\Lambda_i^{j}\right|$$

comparing the sum of the absolute value of the soft information of N codeword bits output by the LDPC code decoder after the jth iteration

$$S^j = \sum_{i=1}^{k}\left|\Lambda_i^{j-1}\right|$$

with the sum of the absolute value of the soft information of N codeword bits output by the LDPC code decoder after the j-1 th iteration, and if $S^j$ is less than or equal to $S^{j-1}$, the data block generated by the LDPC code decoder after the jth iteration is a codeword in the FEC code space; and if $S^j$ is greater than $S^{j-1}$, the data block generated by the LDPC code decoder after the jth iteration is not a codeword in the FEC code space, where i is an integer and i $\in$ {0,1,2,... N-1}, j is an integer greater than or equal to 2, and the eighth threshold $Y_8$ to the twelfth threshold $Y_{12}$ are integers greater than or equal to zero, and the eighth threshold $Y_8$ to the twelfth threshold $Y_{12}$ may be equal or partially equal, or may be completely unequal.

Example 5:

In the wireless broadband application IEEE 802.11 system, the terminal receives the transmission signal containing the data block D and transmitted by the base station, the length of the data block D is 6720 bits, and the data block D includes 10 code blocks. The data block D is generated by the 5040-bit data block K after LDPC encoding, and the information bit sequence length of each code block in the data block K is 504 bits, and an LDPC encoder with a 3/4 rate is used to generate a codeword bit sequence of each code block of 672 bits. 10 code blocks are cascaded to obtain the data block D with a length of 6720 bits.

Herein the data block K is obtained by a transmission block I with a length of 4952 bits after the 8-bit transmission block CRC and the code block CRC encoding; it is described specifically as follows.

The 8-bit transmission block CRC is first added to the transmission block I to generate a data block I' with a length of 4960 bits; the code block I' is subjected to code block division to obtain 10 code blocks, each of which has a length of 496 bits, the length of each code block is 504 bits after each code block is added with an 8-bit code block CRC; the 10 code blocks are concatenated to obtain the data block K.

Herein the transmission signal received by the base station is a signal transmitted by the terminal after the data block D has been modulated.

The base station demodulates the received transmission signal to obtain the estimation $\tilde{D}$ of the data block D, performs code block division on the $\tilde{D}$ to obtain 10 code blocks, inputs the 10 code blocks to the LDPC code decoder, respectively, and determines that a data block (a code block) in the $\tilde{D}$ is a codeword in the code space in the following manner:

> comparing soft information $\Lambda_i^j$ of N codeword bits output by an LDPC code decoder after the jth iteration with the eighth threshold $Y_8$, and if $\Lambda_i^j \geq Y_8$, the bit i is judged to be "1 ", if $\Lambda_i^j < Y_8$ the bit i is judged to be 0, and generating the estimation $\tilde{E}$ of the data block according to the judging result, where i is an integer and i ∈ {0,1,2,... N-1}, j is an integer greater than or equal to 1;
> if $\tilde{E} \times H^T = 0$, $\tilde{E}$ generated by the LDPC code decoder after the jth iteration is a codeword in the FEC code space; and if $\tilde{E} \times H^T \neq 0$, the $\tilde{E}$ is not a codeword in the FEC code space, where H is a check matrix of the LDPC code.

In the present example, the data block D is a transmission block including a plurality of code blocks. If all the code blocks are codewords in the code space, the data block $\tilde{D}$ is a codeword in the code space, otherwise, the data block $\tilde{D}$ is not a codeword in the code space.

In the present example, the data block D is a transmission block including a plurality of code blocks. If the following conditions are satisfied at the same time, the CRC check of $\tilde{K}$ is correct, otherwise, the CRC check of the $\tilde{K}$ is wrong.

Condition 1: In the $\tilde{K}$, the code block CRC checks of all the code blocks are passed.

Condition 2: In the $\tilde{K}$, after the CRC of each code block is removed, the estimation $\tilde{I'}$ of the data block I' is obtained, and the transmission block CRC check of the $\tilde{I'}$ is passed.

If the $D$ is not a codeword in the code space, the base station judges that the transmission block I is not received correctly.

If the $D$ is a codeword in the code space, and the CRC check of $the \tilde{K}$ is correct, the base station judges that the transmission block I is received correctly, otherwise, the base station judges that the transmission block I is not received correctly.

In the present embodiment, if the base station judges that the transmission block I is received correctly, the base station feeds back the ACK to the terminal; if the base station judges that the transmission block I is not received correctly, the base station feeds back the NACK to the terminal.

The exemplary embodiment of the present disclosure achieves the following technical effects. In the IEEE 802.11, the code block generally does not have a CRC, and if the data is not received correctly, the entire transmission block needs to be retransmitted. In order to improve the retransmission efficiency, it is possible to add a CRC to the code block, and retransmission can only be done for the wrong code block. However, if the CRC length is too long, it will bring more redundancy and reduce the transmission efficiency. If the CRC is too short, it will make the error detection performance not credible. By using the method of the present disclosure, CRC of only 8 bits is added for each code block so as to reach the detection target of the code block level, and the proportion of the increased CRC redundancy does not exceed 2%.

Exemplary embodiment three

The difference between the exemplary embodiment three and the exemplary embodiment one is that, in the exemplary embodiment three, the FEC is a convolution code.

Step S805: It is determined that the data block (a code block or transmission block) in the D is a codeword in the code space by at least one of the following manners one to seven or any combination thereof.

Manner one:

> comparing the symbol $\mathrm{sign}(\Lambda_i^j)$ of soft information of K bits output by the convolution code decoder after the jth iteration with the soft information $\mathrm{sign}(\Lambda_i^{j-1})$ output by a decoder after the j-1 th iteration, and if $\mathrm{sign}(\Lambda_i^j)$ and $\mathrm{sign}(\Lambda_i^{j-1})$ of each bit are the same, the data block generated by the convolution code decoder after the jth iteration is a codeword in the FEC code space; and if $\mathrm{sign}(\Lambda_i^j)$ and

$\mathrm{sign}(\Lambda_i^{j-1})$ of at least one bit are different, the data block generated after the jth iteration is not a codeword in the FEC code space, where i is an integer and i $\in$ {0,1,2,... K-1}, j is an integer greater than or equal to 2.

Manner two:

comparing the symbol $\mathrm{sign}(\Lambda_i^{j})$ of soft information of K bits output by the convolution code decoder after the jth iteration with the soft information $\mathrm{sign}(\Lambda_i^{j-1})$ output by a decoder after the j-1th iteration, and if the number of bits in which $\mathrm{sign}(\Lambda_i^{j})$ and $\mathrm{sign}(\Lambda_i^{j-1})$ are the same is greater than or equal to a thirteenth threshold Y$_{13}$, the data block generated after the jth iteration is a codeword in the FEC code space; and if the number of bits in which $\mathrm{sign}(\Lambda_i^{j})$ and $\mathrm{sign}(\Lambda_i^{j-1})$ are the same is less than or equal to the thirteenth threshold Y$_{13}$, the data block generated after the jth iteration is not a codeword in the FEC code space, where i is an integer and i $\in$ {0,1,2,... K-1}, j is an integer greater than or equal to 2; or

if the number of bits in which $\mathrm{sign}(\Lambda_i^{j})$ and $\mathrm{sign}(\Lambda_i^{j-1})$ are different is greater than or equal to a fourteenth threshold Y$_{14}$, the data block generated by the convolution code decoder after the jth iteration is a codeword in the FEC code space; and if the number of bits in which $\mathrm{sign}(\Lambda_i^{j})$ and $\mathrm{sign}(\Lambda_i^{j-1})$ are different is greater than the fourteenth threshold Y$_{14}$, the data block generated after the jth iteration is not a codeword in the FEC code space.

Manner three:

comparing the absolute value $\left|\Lambda_i^{j}\right|$ of the soft information of K bits output by the convolution code decoder after the jth iteration with a fifteenth threshold Y$_{15}$, and if the maximum value in $\left|\Lambda_i^{j}\right|$ is greater than the fifteenth threshold Y$_{15}$, the data block generated by the convolution code decoder after the jth iteration is a codeword in the FEC code space; and if the minimum value in $\left|\Lambda_i^{j}\right|$ is less than or equal to the fifteenth threshold Y$_{15}$, the data block generated after the jth iteration is not a codeword in the FEC code space, where i is an integer and i $\in$ {0,1,2,... K-1}, j is an integer greater than or equal to 1.

Manner four:

comparing the mean value $S^{j} = \dfrac{1}{\mathrm{K}}\sum_{i=1}^{k}\left|\Lambda_i^{j}\right|$ of the absolute value of the soft information of K bits output by the convolution code decoder after the jth iteration with a sixteenth threshold Y$_{16}$, and if $S^j$ is greater than the sixteenth threshold Y$_{16}$, the data block generated by the convolution code decoder after the jth iteration is a codeword in the FEC code space; and if $S^j$ is less than or equal to the sixteenth threshold Y$_{16}$, the data block generated after the jth iteration is not a codeword in the FEC code space, where i is an integer and i $\in$ {0,1,2,... K-1}, j is an integer greater than or equal to 1.

Manner five:

comparing the sum $S^{j} = \sum_{i=1}^{k}\left|\Lambda_i^{j}\right|$ of the absolute value of the soft information of K bits output by the convolution code decoder after the jth iteration with the sum $S^{j-1} = \sum_{i=1}^{k}\left|\Lambda_i^{j-1}\right|$ of the absolute value of the soft information of K bits output by the LDPC code decoder after the j-1th iteration, and if $S^j$ is less than or equal to $S^{j-1}$, the data block is a codeword in the FEC code space; and if $S^j$ is greater than $S^{j-1}$, the data block is not a codeword in the FEC code space, where i is an integer and i $\in$ {0,1,2,... K-1}, j is an integer greater than or equal to 2, and the thirteenth threshold Y$_{13}$ to the sixteenth threshold Y$_{16}$ are integers greater than or equal to zero.

Example 6

In the wireless broadband application IEEE 802.11 system, the terminal receives the transmission signal containing the data block D and transmitted by the base station, the length of the data block D is 6720 bits, and the data block D includes 10 code blocks. The data block D is generated by the 5040-bit data block K after convolution code encoding, and the information bit sequence length of each code block in the data block K is 504 bits, and a convolution encoder with a 3/4 rate is used to generate a codeword bit sequence of each code block of 672 bits. 10 code blocks are cascaded to obtain the data block D with a length of 6720 bits.

Herein the data block K is obtained by a transmission block I with a length of 4952 bits after the 8-bit transmission block CRC and the code block CRC encoding; it is described specifically as follows.

The 8-bit transmission block CRC is first added to the transmission block I to generate a data block I' with a length of 496 bits; the code block I' is subjected to code block division to obtain 10 code blocks, each of which has a length of 496 bits, the length of each code block is 504 bits after each code block is added with an 8-bit code block CRC; the 10 code blocks are concatenated to obtain the data block K.

Herein the transmission signal received by the base station is a signal transmitted by the terminal after the data block D has been modulated.

The base station demodulates the received transmission signal to obtain the estimation $\tilde{D}$ of the data block D, performs code block division on the $\tilde{D}$ to obtain 10 code blocks, inputs the 10 code blocks to a SOVA decoder of the convolution code, respectively, and determines that a data block (a code block) in the $\tilde{D}$ is a codeword in the code space in the following manner:

comparing the symbol $\text{sign}(\Lambda_i^j)$ of soft information of K bits output by the convolution code decoder after the jth iteration with the soft information $\text{sign}(\Lambda_i^{j-1})$ output by a decoder after the j-1th iteration, and if $\text{sign}(\Lambda_i^j)$ and $\text{sign}(\Lambda_i^{j-1})$ of each bit are the same, the data block generated by the convolution code decoder after the jth iteration is a codeword in the FEC code space; and if $\text{sign}(\Lambda_i^j)$ and $\text{sign}(\Lambda_i^{j-1})$ of at least one bit are different, the data block generated after the jth iteration is not a codeword in the FEC code space, where i is an integer and i $\in$ {0,1,2,... K-1}, j is an integer greater than or equal to 2.

In the present example, the data block D is a transmission block including a plurality of code blocks. If all the code blocks are codewords in the code space, the data block $\tilde{D}$ is a codeword in the code space, otherwise, the data block $\tilde{D}$ is not a codeword in the code space.

In the present example, the data block D is a transmission block including a plurality of code blocks. If the following conditions are satisfied at the same time, the CRC check of $\tilde{K}$ is correct, otherwise, the CRC check of the $\tilde{K}$ is wrong.

Condition 1: In the $\tilde{K}$, the code block CRC checks of all the code blocks are passed.

Condition 2: In the $\tilde{K}$, after the CRC of each code block is removed, the estimation $\tilde{I}'$ of the data block I' is obtained, and the transmission block CRC check of $\tilde{I}'$ is passed.

If the $\tilde{D}$ is not a codeword in the code space, the base station judges that the transmission block I is not received correctly.

If the $\tilde{D}$ is a codeword in the code space, and the CRC check of the $\tilde{K}$ is correct, the base station judges that the transmission block I is received correctly, otherwise, the base station judges that the transmission block I is not received correctly.

In the present embodiment, if the base station judges that the transmission block I is received correctly, the base station feeds back the ACK to the terminal; if the base station judges that the transmission block I is not received correctly, the base station feeds back the NACK to the terminal.

The exemplary embodiment of the present disclosure achieves the following technical effects. In the IEEE 802.11, the code block generally does not have a CRC, and if the data is not received correctly, the entire transmission block needs to be retransmitted. In order to improve the retransmission efficiency, it is possible to add a CRC to the code block, and retransmission can only be done for the wrong code block. However, if the CRC length is too long, it will bring more redundancy and reduce the transmission efficiency. If the CRC is too short, it will make the error detection performance not credible. By using the method of the present disclosure, CRC of only 8 bits is added for each code block so as to reach the detection target of the code block level, and the proportion of the increased CRC redundancy does not exceed 2%.

The units described as a separating component may or may not be physically separate, and the components shown as units may or may not be physical units, i.e., may be located in one place or may be distributed over a plurality of network units. A part or all of the units may be selected according to the actual needs to achieve the object of the solution of the present embodiment.

Alternatively, all or a part of the steps of the embodiments described above may also be implemented using an integrated circuit. These steps may be separately made into one integrated circuit module or a plurality of modules or steps therein may be made into a single integrated circuit module for implementing. Thus, the present disclosure is not limited to any particular combination of hardware and software.

In another embodiment, there is also provided a software for performing the technical solutions described in the above embodiments and exemplary embodiments.

In another embodiment, there is also provided a storage medium in which the above software is stored, including but not limited to optical disks, floppy disks, hard disks, erasable memories, and so on.

It is to be understood that the terms "first", "second" and so on in the specification and claims of the present disclosure and in the accompanying drawings are for distinguishing similar objects and are not necessarily used to describe a particular order or sequence. It is to be understood that the objects so used are interchangeable where appropriate so that the embodiments of the present disclosure described herein can be carried out in an order other than those illustrated or described herein. In addition, the terms "including" and "having" and any variations thereof are intended to cover a non-exclusive inclusion, for example, a process, method, system, product or device that includes a series of steps or units are not necessarily limited to these steps or units that are clearly listed, but may include other steps or units that are not clearly listed or inherent to these processes, methods, products, or devices.

The embodiment of the present disclosure has the following technical effect: the problems that a transmission rate decreases due to the fact that a CRC check code is too long and a false detection rate cannot be ensured due to the fact that the CRC check code is too short are solved, so as to reduce the length of the CRC in the case of meeting the requirement of the system error detection rate, thereby reducing the data redundancy rate and improving the transmission efficiency.

Obviously, those skilled in the art should know that each module or step of the embodiment of the present disclosure may be implemented by a universal computing device, and the modules or steps may be concentrated on a single computing device or distributed on a network formed by a plurality of computing devices, and may optionally be implemented by programmable codes executable for the computing devices, so that the modules or steps may be stored in a storage device for execution with the computing devices, and, in some cases, the steps shown or described may be performed in a order different from the order herein, or the modules or steps may form each integrated circuit module, or multiple modules or steps therein may form a single integrated circuit module for implementation. As a consequence, the present disclosure is not limited to any specific hardware and software combination.

The above is only the exemplary embodiment of the present disclosure and not intended to limit the present disclosure, and for the technician of the field, the present disclosure may have various modifications and variations. Any modifications, equivalent replacements, improvements and the like shall fall within the scope of protection as defined in the present disclosure.

**Industrial Applicability**

According to the technical solution provided by the embodiment of the present disclosure, the technical solution of checking the received data block by comprehensively using the FEC code space and the CRC check solves the problems that a transmission rate decreases due to the fact that a CRC check code is too long and a false detection rate cannot be ensured due to the fact that the CRC check code is too short, so as to reduce the length of the CRC in the case of meeting the requirement of the system error detection rate, thereby reducing the data redundancy rate and improving the transmission efficiency.

**Claims**

1. A data checking method, comprising:

receiving a transmission signal containing a first data block and transmitted by a transmission node, wherein the first data block has a length of N bits, and the first data block is generated by performing a Forward Error Correction code (FEC) encoding on a second data block which has a length of K bits, and the second data block is generated by performing a Cyclic Redundancy Check code (CRC) encoding on a third data block which has a length of L bits, where N, K and L are positive integers, and $N \geq K > L$;

obtaining a first estimation data block of the first data block according to the transmission signal, and obtaining a second estimation data block of the second data block according to the transmission signal; and

checking the third data block according to a relationship between the first estimation data block and an FEC code space and/or a CRC check result of the second estimation data block.

2. The method as claimed in claim 1, wherein checking the third data block according to a relationship between the first estimation data block and an FEC code space and/or a CRC check result of the second estimation data block, comprises:

judging that the third data block is received correctly when the first estimation data block is a codeword of the FEC code space and the CRC check of the second estimation data block is correct; and

judging that the third data block is not received correctly when the first estimation data block is not a codeword of the FEC code space and/or the CRC check of the second estimation data block fails.

3. The method as claimed in claim 2, wherein when the first data block is a code block or a transmission block containing a code block, the first estimation data block is a codeword of the FEC code space indicating that: the code block or the transmission block is a codeword in the FEC code space; or

when the first data block is a transmission block containing a plurality of data blocks, the first estimation data block is a codeword of the FEC code space indicating that: the plurality of data blocks are codewords in the FEC code space.

4. The method as claimed in claim 2, wherein when it is judged that the third data block is received correctly, transmitting Acknowledgment (ACK) information to the transmission node; and

when it is judged that the third data block is not received correctly, transmitting Non-Acknowledgment (NACK) information to the transmission node.

**5.** The method as claimed in claim 2, wherein the FEC encoding comprises at least one of: a Turbo code, a Low Density Parity Check (LDPC) code, and a convolution code.

**6.** The method as claimed in claim 5, wherein when the FEC encoding is a Turbo code, determining whether the data block is a codeword in the FEC code space by at least one of the following manners:

manner one:

comparing side information $\Lambda_i^{e_1}$ corresponding to K bits output by a first component decoder after the jth iteration with the first threshold $Y_1$, respectively, wherein if

$\Lambda_i^{e_1} \geq Y_1$, the bit i is judged to be "1", if

$\Lambda_i^{e_1} < Y_1$, the bit i is judged to be 0, and generating the bit sequence $E_1$ according to the judging result, where i is an integer and i $\in$ {0,1,2,... K-1}, j is an integer greater than or equal to 1, and $e_1$ represents that

the $\Lambda_i^{e_1}$ is the side information output by the first component decoder;

comparing side information $\Lambda_i^{e_2}$ corresponding to K bits output by a second component decoder in the jth iteration with the first threshold $Y_1$, respectively, wherein if

$\Lambda_i^{e_2} \geq Y_1$, the bit i is judged to be "1 ", if

$\Lambda_i^{e_2} < Y_1$, the bit i is judged to be 0, and generating the bit sequence $E_2$ according to the judging result, where $e_2$ represents

that the $\Lambda_i^{e_2}$ is the side information output by the second component decoder;
interleaving the bit sequence $E_1$ using an inner interleaver pattern of the Turbo code, generating an interleaved bit sequence $E_1^{int}$, and comparing $E_1^{int}$ with $E_2$, wherein if the $E_1^{int} = E_2$, the data block generated by being decoded by the Turbo code after j iterations is a codeword in the FEC code space; if $E_1^{int} \neq E_2$, the data block generated after j iterations is not a codeword in the FEC code space, where int represents that the $E_1^{int}$ is the interleaved information or bit sequence; or
deinterleaving the $E_2$ using an inner interleaver of the Turbo code, generating an deinterleaved bit sequence $E_2^{dei}$, and comparing $E_1$ with $E_2^{dei}$, wherein if the $E_2^{dei} =$

$E_1$, the data block generated by being encoded by the Turbo code after j iterations is a codeword in the FEC code space; if $E_2^{dei} \neq E_1$, the data block generated after j iterations is not a codeword in the FEC code space, where die represents that the $E_2^{dei}$ is the deinterleaved information or bit sequence;

manner two:

comparing the symbol $\text{sign}(\Lambda_i^j)$ of soft information of K bits output by the Turbo code decoder after the jth iteration with the soft information output by a decoder after the j-1 th iteration, wherein if $\text{sign}(\Lambda_i^j)$

and $\text{sign}(\Lambda_i^{j-1})$ of each bit are the same, the data block generated by the Turbo code decoder after the jth iteration is a codeword in the FEC code space; and $\text{sign}(\Lambda_i^j)$ and

$\text{sign}(\Lambda_i^{j-1})$ of at least one bit are different, the data block generated by the Turbo code decoder after the jth iteration is not a codeword in the FEC code space, where i is an integer and i $\in$ {0,1,2,... K-1}, j is an integer greater than or equal to 2;

manner three:

comparing the symbol $\text{sign}(\Lambda_i^j)$ of soft information of K bits output by the Turbo code decoder after the jth iteration with the

soft information $\text{sign}(\Lambda_i^{j-1})$ output by a decoder after the j-1th iteration, wherein if the number of bits in which $\text{sign}(\Lambda_i^j)$ and

$\text{sign}(\Lambda_i^{j-1})$ are the same is less than or equal to a second threshold $Y_2$, the data block generated after the jth iteration is not a codeword in the FEC code space, where i is an integer and i $\in$ {0,1,2,... K-1}, j is an integer greater than or equal to 2; or

if the number of bits in which $\text{sign}(\Lambda_i^j)$

and $\text{sign}(\Lambda_i^{j-1})$ are different is less than or equal to a third threshold $Y_3$, the data block generated by the Turbo code decoder after the jth iteration is a codeword in the FEC code space; and if the number of bits in

which $\text{sign}(\Lambda_i^j)$ and $\text{sign}(\Lambda_i^{j-1})$ are different is greater than the third threshold $Y_3$,

the data block generated after the jth iteration is not a codeword in the FEC code space;

manner four:

comparing the symbol $\mathrm{sign}(\Lambda_i^{a_2})$ of priori information of K bits input to a second component decoder in the jth iteration and the symbol $\mathrm{sign}(\Lambda_i^{e_2})$ of side information of K bits output by a second component decoder in the jth iteration, wherein if the number of bits in which $\mathrm{sign}(\Lambda_i^{a_2})$ and $\mathrm{sign}(\Lambda_i^{e_2})$ are the same is less than or equal to a fourth threshold $Y_4$, the data block generated by the Turbo code decoder after the jth iteration is a codeword in the FEC code space, where i is an integer and $i \in \{0,1,2,... K-1\}$, j is an integer greater than or equal to 2, where a2 represents that the $\mathrm{sign}(\Lambda_i^{a_2})$ is priori information input to the second component decodern; or if the number of bits in which $\mathrm{sign}(\Lambda_i^{a_2})$ and $\mathrm{sign}(\Lambda_i^{e_2})$ are different is less than or equal to a fifth threshold $Y_5$, the data block generated by the Turbo code decoder after the jth iteration is a codeword in the FEC code space; and if the number of bits in which $\mathrm{sign}(\Lambda_i^{a_2})$ and $\mathrm{sign}(\Lambda_i^{e_2})$ are different is greater than the fifth threshold $Y_5$, the data block generated after the jth iteration is not a codeword in the FEC code space;

manner five:

comparing the absolute value $\left|\Lambda_i^j\right|$ of the soft information of K bits output by the Turbo code decoder after the jth iteration with a sixth threshold $Y_6$, wherein if the maximum value in $\left|\Lambda_i^j\right|$ is greater than the sixth threshold $Y_6$, the data block generated by the Turbo code decoder after the jth iteration is a codeword in the FEC code space; and if the minimum value in $\left|\Lambda_i^j\right|$ is less than or equal to the sixth threshold $Y_6$, the data block generated by the Turbo code decoder after the jth iteration is not a codeword in the FEC code space, where i is an integer and $i \in \{0,1,2,... K-1\}$, j is an integer greater than or equal to 1;

manner six:

comparing the mean value $S^j = \dfrac{1}{\mathrm{K}} \sum_{i=1}^{k} \left|\Lambda_i^j\right|$ of the absolute value of the soft information of K bits output by the Turbo code decoder after the jth iteration with a seventh threshold $Y_7$, wherein if $S^j$ is greater than the seventh threshold $Y_7$, the data block generated by the Turbo code decoder after the jth iteration is a codeword in the FEC code space; and if $S^j$ is less than or equal to the seventh threshold $Y_7$, the data block generated by the Turbo code decoder after the jth iteration is not a codeword in the FEC code space, where i is an integer and $i \in \{0,1,2,... K-1\}$, j is an integer greater than or equal to 1;

manner seven:

comparing the sum $S^j = \sum_{i=1}^{k} \left|\Lambda_i^j\right|$ of the absolute value of the soft information of K bits output by the Turbo code decoder after the jth iteration with the sum $S^{j-1} = \sum_{i=1}^{k} \left|\Lambda_i^{j+1}\right|$ of the absolute value of the soft information of K bits output by the Turbo code decoder after the j-1th iteration, wherein if $S^j$ is less than or equal to $S^{j-1}$, the data block generated by the Turbo code decoder after the jth iteration is a codeword in the FEC code space; and if $S^j$ is greater than $S^{j-1}$, the data block generated by the Turbo code decoder after the jth iteration is not a codeword in the FEC code space, where i is an integer and $i \in \{0,1,2,... K-1\}$, j is an integer greater than or equal to 2, and the first threshold $Y_1$ to the seventh threshold $Y_7$ are integers greater than or equal to zero.

7. The method as claimed in claim 5, wherein when the FEC encoding is the LDPC code, determining whether the data block is a codeword in the FEC code space by at least one of the following manners:

manner one:

comparing soft information $\Lambda_i^j$ of N codeword bits output by an LDPC code decoder after the jth iteration with the eighth threshold $Y_8$, wherein if $\Lambda_i^j \geq Y_8$, the bit i is judged to be "1", if $\Lambda_i^j < Y_8$, the bit i is judged to be 0, and generating the estimation $\tilde{E}$ of the data block according to the judging result, where i is an integer and i $\in$ {0,1,2,... N-1}, j is an integer greater than or equal to 1;

if $\tilde{E} \times H^T = 0$, $\tilde{E}$ generated by the LDPC code decoder after the jth iteration is a codeword in the FEC code space; and if $\tilde{E} \times H^T \neq 0$, the $\tilde{E}$ is not a codeword in the FEC code space, where H is a check matrix of the LDPC code;

manner two:

comparing soft information $\Lambda_i^j$ of N codeword bits output by an LDPC code decoder after the jth iteration with the eighth threshold $Y_8$, wherein if $\Lambda_i^j \geq Y_8$, the bit i is judged to be "1 ", if $\Lambda_i^j < Y_8$, the bit i is judged to be 0, generating the estimation $\tilde{E}$ of the first data block according to the judging result, and generating the estimation $\tilde{F}$ of the bit sequence by taking the first K bits for the estimation $\tilde{E}$, where i is an integer and i $\in$ {0,1,2,... N-1}, j is an integer greater than or equal to 1;

generating the data block C by performing LDPC encoding on the $\tilde{F}$, wherein if $\tilde{E} = C$, the $\tilde{E}$ is a codeword in the FEC code space; and if $\tilde{E} \neq C$, the $\tilde{E}$ is not a codeword in the FEC code space;

manner three:

comparing the symbol $sign(\Lambda_i^j)$ of soft information of N codeword bits output by a LDPC code decoder after the jth iteration with the soft information $sign(\Lambda_i^{j-1})$ output by a decoder after the j-1th iteration, wherein if $sign(\Lambda_i^j)$ and $sign(\Lambda_i^{j-1})$ of each bit are the same, the data block generated by the LDPC code decoder after the jth iteration is a codeword in the FEC code space; and if $sign(\Lambda_i^j)$ and $sign(\Lambda_i^{j-1})$ of at least one bit are different, the data block generated after the jth iteration is not a codeword in the FEC code space, where i is an integer and i $\in$ {0,1,2,... N-1}, j is an integer greater than or equal to 2;

manner four:

comparing the symbol $sign(\Lambda_i^j)$ of soft information of N codeword bits output by a LDPC code decoder after the jth iteration with the soft information $sign(\Lambda_i^{j-1})$ output by a decoder after the j-1th iteration, wherein if the number of bits in which $sign(\Lambda_i^j)$ and $sign(\Lambda_i^{j-1})$ are the same is greater than or equal to a ninth threshold $Y_9$, the data block generated by the LDPC code decoder after the jth iteration is a codeword in the FEC code space; if the number of bits in which $sign(\Lambda_i^j)$ and $sign(\Lambda_i^{j-1})$ are different is less than or equal to the ninth threshold $Y_9$, the data block generated after the jth iteration is not a codeword in the FEC code space, where i is an integer and i $\in$ {0,1,2,... N-1}, j is an integer greater than or equal to 2; or

if the number of bits in which $sign(\Lambda_i^j)$ and $sign(\Lambda_i^{j-1})$ are different is less than or equal to a tenth threshold $Y_{10}$, the data block generated by the LDPC code decoder after the jth iteration is a codeword in the FEC code space; and if the number of bits in which $sign(\Lambda_i^j)$ and $sign(\Lambda_i^{j-1})$ are different is greater than the tenth threshold $Y_{10}$, the data block generated after the jth iteration is not a codeword in the FEC code space;

manner five:

comparing the absolute value of the soft information of N codeword bits output by the LDPC code decoder after the jth iteration with an eleventh threshold $Y_{11}$, wherein if the minimum value in $\left|\Lambda_i^j\right|$ is greater than the eleventh threshold $Y_{11}$, the data block generated by the LDPC code decoder after the jth iteration is a codeword in the FEC code space; and if the minimum value in $\left|\Lambda_i^j\right|$ is less than or equal to the eleventh threshold $Y_{11}$, the data block generated by the LDPC code decoder after the jth iteration is not a codeword in the FEC code space, where i is an integer and i ∈ {0,1,2,... N-1}, j is an integer greater than or equal to 1;

manner six:

comparing the mean value $S^j = \frac{1}{N}\sum_{i=1}^{k}\left|\Lambda_i^j\right|$ of the absolute value of the soft information of N codeword bits output by the LDPC code decoder after the jth iteration with a twelfth threshold $Y_{12}$, wherein if $S^j$ is greater than the twelfth threshold $Y_{12}$, the data block generated by the LDPC code decoder after the jth iteration is a codeword in the FEC code space; and if $S^j$ is less than or equal to the twelfth threshold $Y_{12}$, the data block generated by the LDPC code decoder after the jth iteration is not a codeword in the FEC code space, where i is an integer and i ∈ {0,1,2,... N-1}, j is an integer greater than or equal to 1;

manner seven:

comparing the *sum* $S^j = \sum_{i=1}^{k}\left|\Lambda_i^j\right|$ of the absolute value of the soft information of N codeword bits output by the LDPC code decoder after the jth iteration with the sum $S^j = \sum_{i=1}^{k}\left|\Lambda_i^{j-1}\right|$ of the absolute value of the soft information of N codeword bits output by the LDPC code decoder after the j-1th iteration, wherein if $S^j$ is less than or equal to $S^{j-1}$, the data block generated by the LDPC code decoder after the jth iteration is a codeword in the FEC code space; and if $S^j$ is greater than $S^{j-1}$, the data block generated by the LDPC code decoder after the jth iteration is not a codeword in the FEC code space, where i is an integer and i ∈ {0,1,2,... N-1}, j is an integer greater than or equal to 2, and the eighth threshold $Y_8$ to the twelfth threshold $Y_{12}$ are integers greater than or equal to zero.

8. The method as claimed in claim 5, wherein when the FEC encoding is the convolution code, determining whether the data block is a codeword in the FEC code space by at least one of the following manners:

manner one:

comparing the symbol $\mathrm{sign}(\Lambda_i^j)$ of soft information of K bits output by the convolution code decoder after the jth iteration with the soft information $\mathrm{sign}(\Lambda_i^{j-1})$ output by a decoder after the j-1 th iteration, wherein if $\mathrm{sign}(\Lambda_i^j)$ and $\mathrm{sign}(\Lambda_i^{j-1})$ of each bit are the same, the data block generated by the convolution code decoder after the jth iteration is a codeword in the FEC code space; and if $\mathrm{sign}(\Lambda_i^j)$ and $\mathrm{sign}(\Lambda_i^{j-1})$ of at least one bit are different, the data block generated after the jth iteration is not a codeword in the FEC code space, where i is an integer and i ∈ {0,1,2,... K-1}, j is an integer greater than or equal to 2;

manner two:

comparing the symbol $\mathrm{sign}(\Lambda_i^j)$ of soft information of K bits output by the convolution code decoder after the jth iteration with the soft information $\mathrm{sign}(\Lambda_i^{j-1})$ output by a decoder after the j-1th iteration, wherein if the number of bits in which $\mathrm{sign}(\Lambda_i^j)$ and $\mathrm{sign}(\Lambda_i^{j-1})$ are the same is greater than or equal to a thirteenth threshold $Y_{13}$, the data block generated after the jth iteration is a codeword in the FEC code space; and if the number of bits in which $\mathrm{sign}(\Lambda_i^j)$ and $\mathrm{sign}(\Lambda_i^{j-1})$ are the same is less than or equal to the thirteenth threshold $Y_{13}$, the data block generated after the jth iteration is not a codeword in the FEC code space, where i is an integer and i ∈ {0,1,2,... K-1}, j is an integer greater than or equal to 2; or

if the number of bits in which $\mathrm{sign}(\Lambda_i^j)$ and $\mathrm{sign}(\Lambda_i^{j-1})$ are different is greater than or equal to a fourteenth threshold $Y_{14}$, the data block generated by the convolution code decoder after the jth iteration is a codeword in the FEC code space; and if the number of bits in which $\mathrm{sign}(\Lambda_i^j)$ and $\mathrm{sign}(\Lambda_i^{j-1})$ are different is greater than the fourteenth threshold $Y_{14}$, the data block

generated after the jth iteration is not a codeword in the FEC code space;

manner three:

comparing the absolute value $\left|\Lambda_i^j\right|$ of the soft information of K bits output by the convolution code decoder after the jth iteration with a fifteenth threshold $Y_{15}$, wherein if the maximum value in $\left|\Lambda_i^j\right|$ is greater than the fifteenth threshold $Y_{15}$, the data block generated by the convolution code decoder after the jth iteration is a codeword in the FEC code space; and if the minimum value in $\left|\Lambda_i^j\right|$ is less than or equal to the fifteenth threshold $Y_{15}$, the data block generated after the jth iteration is not a codeword in the FEC code space, where i is an integer and $i \in \{0,1,2,... K-1\}$, j is an integer greater than or equal to 1;

manner four:

comparing the mean value

$$S^j = \frac{1}{K} \sum_{i=1}^{k} \left|\Lambda_i^j\right|$$

of the absolute value of the soft information of K bits output by the convolution code decoder after the jth iteration with a sixteenth threshold $Y_{16}$, wherein if $S^j$ is greater than the sixteenth threshold $Y_{16}$, the data block generated by the convolution code decoder after the jth iteration is a codeword in the FEC code space; and if $S^j$ is less than or equal to the sixteenth threshold $Y_{16}$, the data block generated after the jth iteration is not a codeword in the FEC code space, where i is an integer and $i \in \{0,1,2,... K-1\}$, j is an integer greater than or equal to 1;

manner five:

comparing the sum $S^j = \sum_{i=1}^{k} \left|\Lambda_i^j\right|$ of the absolute value of the soft information of K bits output by the convolution code decoder after the jth iteration with the sum

$$S^{j-1} = \sum_{i=1}^{k} \left|\Lambda_i^{j-1}\right|$$

of the absolute value of the soft information of K bits output by the LDPC code decoder after the j-1th iteration, wherein if $S^j$ is less than or equal to $S^{j-1}$, the data block is a codeword in the FEC code space; and if $S^j$ is greater than $S^{j-1}$, the data block is not a codeword in the FEC code space, where i is an integer and $i \in \{0,1,2,... K-1\}$, j is an integer greater than or equal to 2, and the thirteenth threshold $Y_{13}$ to the sixteenth threshold $Y_{16}$ are integers greater than or equal to zero.

9. The method as claimed in claim 1, further comprising: determining the length of the CRC according to the length L of the third data block.

10. The method as claimed in claim 9, wherein determining the length of the CRC according to the length L of the third data block, comprising:

dividing the range of values of the length L into T intervals in an ascending order: $L_1, L_2,...... L_T$, where each interval corresponds to the CRCs of different lengths: $L_1^{CRC}, L_2^{CRC},.....L_T^{CRC}$, wherein $L_1^{CRC}, L_2^{CRC},.....L_T^{CRC}$, and T is a positive integer; and

selecting the length of the CRC used for encoding the third data block according to the value interval to which the length L of the third data block belongs.

11. The method as claimed in claim 1, wherein the transmission node comprises at least one of: a base station, a relay node, and a terminal.

12. The method as claimed in claim 11, wherein when the transmission node is a terminal, a transmission signaling for indicating a data checking mode is transmitted to the transmission node, wherein the data checking mode comprises at least one of: checking data according to the FEC code space and/or the CRC check result; and checking data according to the CRC check result.

13. The method as claimed in claim 11, wherein when the transmission node is a base station or a relay node, an indication signaling for configuring the data checking mode and transmitted by the transmission node is received, wherein the data checking mode comprises at least one of: checking data according to the FEC code space and/or the CRC check result; checking data according to the CRC check result.

14. The method as claimed in claim 13, wherein a data checking mode in which data is checked according to the FEC code space and/or the CRC check result is used in one of the following cases:

the length of the transmission block or code block in the first data block is less than the first preset threshold;
the number of repetitions of the transmission block or code block in the first data block is greater than the second preset threshold.

15. The method as claimed in any one of claims 1 to 14, wherein the FEC code space comprises: a set of all codewords generated using the FEC encoding manner.

16. The method as claimed in any one of claims 1 to 14, wherein
obtaining the first estimation data block of the first data block according to the transmission signal comprises: obtaining the first estimation data block by demodulating the transmission signal; and
obtaining the second estimation data block of the second data block according to the transmission signal comprises: obtaining the second estimation data block by demodulating and FEC decoding the transmission signal.

17. A data checking device, comprising:

a receiving module, configured to receive a transmission signal containing a first data block and transmitted by a transmission node, wherein the length of the first data block is N bits, the first data block is generated by performing a Forward Error Correction code (FEC) encoding on a second data block which has a length of K bits, and the second data block is generated by performing a Cyclic Redundancy Check code (CRC) encoding on a third data block which has a length of L bits, where N, K and L are all positive integers, and N≥K>L;
a determining module, configured to obtain a first estimation data block of the first data block according to the transmission signal, and obtain a second estimation data block of the second data block according to the transmission signal; and
a checking module, configured to check the third data block according to a relationship between the first estimation data block and an FEC code space and/or a CRC check result of the second estimation data block.

18. The device as claimed in claim 17, wherein the checking module comprises:

a first judging unit, configured to judge that the third data block is received correctly when the first estimation data block is a codeword of the FEC code space and the CRC check of the second estimation data block is correct; and
a second judging unit, configured to judge that the third data block is not received correctly when the first estimation data block is not a codeword of the FEC code space and/or the CRC check of the second estimation data block fails.

19. The device as claimed in claim 17 or 18, wherein the checking module is configured to check the third data block when the FEC code space comprises the following: a set of all codewords generated using the FEC encoding manner.

**Fig. 1**

**Fig. 2**

Priori information

External information

First check bit soft information

External informatio n

Priori information

Information bit soft information

second check bit soft information

soft information Output form the decoder

Deinterleave

interleave

interleave

second component decoder

Deinterleav

First component decoder

## Fig. 3

$n(f) \setminus \{x\}$

$h_1$

$\mu_{h_1 \rightarrow x}(x)$

$\mu_{y_1 \rightarrow f}(y_1)$

$y_1$

$h_2$

$\mu_{x \rightarrow f}(x)$

$y_2$

$x$

$f$

$\mu_{f \rightarrow x}(x)$

$n(x) \setminus \{f\}$

## Fig. 4

Receive a transmission signal containing a first data block and transmitted by a transmission node, wherein the length of the first data block is N bits, the first data block is generated by a second data block, the length of which is K bits, after FEC encoding, and the second data block is generated by a third data block, the length of which is L bits, after CRC encoding, where N, K and L are all positive integers, and $N \geq K > L$.

S502

Obtain a first estimation data block of the first data block according to the transmission signal, and Obtain a second estimation data block of the second data block according to the transmission signal.

S504

Check the third data block according to a relationship between the first estimation data block and an FEC code space and/or a CRC check result of the second estimation data block.

S506

# Fig. 5

Receiving module 60

Determining module 62

Checking module 64

# Fig. 6

Receiving module 60

Determining module 62

First judging unit 640

Second judging unit 642

Checking module 64

## Fig. 7

The first transmission node receives a transmission signal containing a data block D and transmitted by the second transmission node

S802

The first transmission node generates an estimation matrix of the data block D and an estimation matrix of the data block K according to the transmission signal

S804

If the estimation matrix of the data block D is a codeword in the Turbo code space, and the CRC check of the estimation matrix of the data block K is correct, the first transmission node judges that the information block I is received correctly; if the estimation matrix of the data block D is not a codeword in the Turbo code space, or the CRC check of the estimation matrix of the data block K is wrong, the first transmission node judges that that the information block I is Not received correctly

S806

If the first transmission node judges that the information block I is received correctly, an ACK message is transmitted to the second transmission node; and if the first transmission node judges that the information block I is receiving wrongly, NACK information is transmitted to the second transmission node

S808

## Fig. 8

**Fig. 9**

# INTERNATIONAL SEARCH REPORT

| International application No. |
| --- |
| PCT/CN2015/076490 |

### A. CLASSIFICATION OF SUBJECT MATTER

H04L 1/00 (2006.01) i

According to International Patent Classification (IPC) or to both national classification and IPC

### B. FIELDS SEARCHED

Minimum documentation searched (classification system followed by classification symbols)

H04W; H04Q; H04L; H04M; H04B

Documentation searched other than minimum documentation to the extent that such documents are included in the fields searched

Electronic data base consulted during the international search (name of data base and, where practicable, search terms used)

WPI; EPODOC; CNKI; IEEE; CNPAT: CRC, LDPC, Turbo, FEC, codeword, convolutional code

### C. DOCUMENTS CONSIDERED TO BE RELEVANT

| Category* | Citation of document, with indication, where appropriate, of the relevant passages | Relevant to claim No. |
| --- | --- | --- |
| Y | CN 101034953 A (SIEMENS COMMUNICATION NETWORKS LTD. BEIJING) 12 September 2007 (12.09.2007) description, page 2, line 7 to page 10, line 8 and figure 4 | 1-5, 9, 11-19 |
| Y | CN 101483503 A (HUAWEI TECHNOLOGIES CO., LTD.) 15 July 2009 (15.07.2009) description, page 15, lines 4-11 | 1-5, 9, 11-19 |
| A | CN 101394255 A (XIDIAN UNIVERSITY) 25 March 2009 (25.03.2009) the whole document | 1-19 |
| A | WO 2009114391 A1 (INTERDIGITAL PATENT HOLDINGS, INC.) 17 September 2009 (17.09.2009) the whole document | 1-19 |

☐ Further documents are listed in the continuation of Box C.     ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 27 May 2015 | 17 July 2015 |

| Name and mailing address of the ISA<br>State Intellectual Property Office of the P. R. China<br>No. 6, Xitucheng Road, Jimenqiao<br>Haidian District, Beijing 100088, China<br>Facsimile No. (86-10) 62019451 | Authorized officer<br><br>MIAO, Yu<br><br>Telephone No. (86-10) 62413518 |

Form PCT/ISA/210 (second sheet) (July 2009)

**INTERNATIONAL SEARCH REPORT**
Information on patent family members

| | International application No. |
|---|---|
| | PCT/CN2015/076490 |

| Patent Documents referred in the Report | Publication Date | Patent Family | Publication Date |
|---|---|---|---|
| CN 101034953 A | 12 September 2007 | None | |
| CN 101483503 A | 15 July 2009 | None | |
| CN 101394255 A | 25 March 2009 | None | |
| WO 2009114391 A1 | 17 September 2009 | TW 200943802 A | 16 October 2009 |
| | | US 2009225889 A1 | 10 September 2009 |

Form PCT/ISA/210 (patent family annex) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **VITERBI.** *Viterbi algorithm,* 1967